# EUROPÄISCHE PATENTANMELDUNG

(11) **EP 4 276 386 A1**
(43) Veröffentlichungstag der Anmeldung: **15.11.2023**
(21) Anmeldenummer: 23163117.7
(22) Anmeldetag: 21.03.2023
(51) Int. Cl.: F25B 3/00, F01K 11/04, F04C 19/00, F04C 27/00, F25B 11/02, F25B 31/00

(54) **VORRICHTUNG ZUR KOMPRESSION, EXPANSION, VOLUMENÄNDERUNG, VERDRÄNGUNG EINES FLUIDEN ARBEITSMEDIUMS, THERMOELEKTRISCHER WANDLER UND COMPUTERGESTEUERTES ODER ELEKTRONISCH GESTEUERTES VERFAHREN**

(30) Priorität: 13.05.2022 DE 102022112016; 08.06.2022 DE 102022114439
(71) Anmelder: Ittner, Thilo, 88239 Wangen im Allgäu (DE)
(72) Erfinder: Ittner, Thilo, 88239 Wangen im Allgäu (DE)
(74) Vertreter: Grünecker Patent- und Rechtsanwälte PartG mbB

(57) **Zusammenfassung**

Die Erfindung betrifft eine Vorrichtung zur Kompression, Expansion, Volumenänderung, Verdrängung eines fluiden Arbeitsmediums, das zumindest teilweise aus Gas besteht, wobei die Vorrichtung umfasst: mindestens ein Volumen, das eine Flüssigkeitsmenge einer Flüssigkeit und ein Teilvolumen mit einem Arbeitsmedium umfasst; Volumenbegrenzungselemente, die das Volumen begrenzen und die derart ausgebildet sind, dass ein oder mehrere Durchlässe während einer Kompressions-, Expansions- oder Verdrängungsperiode ein Hinausströmen von maximal einer vorgegebenen Teilmenge der Flüssigkeitsmenge ermöglichen. Während der Kompressions-, Expansions- oder Verdrängungsperiode führt die Flüssigkeitsmenge eine Rotation um eine Rotationsachse aus, wobei die Volumenbegrenzungselemente eine ringförmige Strömung der Flüssigkeitsmenge um die Rotationsachse zu unterbinden, und ist durch eine Verlagerung mindestens eines der Volumenbegrenzungselemente das Volumen in seiner Gesamtgröße veränderbar. Weiter betrifft die Erfindung einen thermoelektrischen Wandler mit mindestens einer der Vorrichtungen und ein computergesteuertes oder elektronisch gesteuertes Verfahren zum Betreiben des thermoelektrischen Wandlers.

## Beschreibung

Die Erfindung betrifft eine Vorrichtung zur Kompression, Expansion, Volumenänderung, Verdrängung eines fluiden Arbeitsmediums gemäß dem Oberbegriff des Anspruchs 1, einen thermoelektrischen Wandler gemäß dem Anspruch 11 und ein computergesteuertes oder elektronisch gesteuertes Verfahren gemäß dem Anspruch 14.

### Stand der Technik

Es gibt bereits Vorrichtungen für die Kompression oder Expansion von Gasen, bei denen diese teilweise oder weitgehend isotherm erfolgt. Ein Beispiel hierfür sind die Kompressions- oder Expansionsräume von Flachplatten-Stirlingmaschinen. Ein weiteres Beispiel sind Flüssigkeitsringpumpen, bei denen ein Gas während der Expansion oder Kompression thermisch an eine Flüssigkeit gekoppelt ist. Flachplatten-Stirlingmaschinen haben den Nachteil, dass der Wärmeübertrag im Kompressions- oder Expansionsraum vom oder auf das Arbeitsgas über einen Wärmetauscher erfolgt, wofür ein höherer Temperaturgradient erforderlich ist, als wenn das Arbeitsgas (d.h. das zu komprimierende oder expandierende Gas) direkt thermisch an das Medium gekoppelt wäre, dem die Wärme entzogen oder zugeführt werden soll (z.B. eine Flüssigkeit wie Wasser als Wärmeträger). Außerdem haben Flachplatten-Stirlingmaschinen einen vergleichsweise aufwendigen Aufbau und erreichen nur geringe Leistungsdichten. Flüssigkeitsringpumpen weisen eine solche direkte Kopplung des Arbeitsgases an eine Flüssigkeit als Wärmeträger auf. Allerdings haben sie den Nachteil, dass während des Betriebs starke Strömungen der Flüssigkeit stattfinden, die durch die exzentrische Rotation des Flügelrads sowie durch die Druckänderungen im zu komprimierenden oder zu expandierenden Gas verursacht werden. Für diese Strömungen muss Energie aus dem Antrieb der Flüssigkeitsringpumpe aufgebracht werden, die aber letztlich nicht der Funktion der Kompression oder Expansion des Arbeitsgases zu Gute kommt, sondern als Strömungsverlust zur Erwärmung der Flüssigkeit führt und so eine Verlustleistung darstellt. Daher sind die Wirkungsgrade von Flüssigkeitsringpumpen auch meist deutlich niedriger als die von anderen Pumpen oder Vorrichtungen zur Kompression oder Expansion von Gasen.

Zur Umwandlung von Wärme/Kälte bzw. Wärmemengen in mechanische/elektrische Energie oder umgekehrt werden heute oft Maschinen eingesetzt, die nach dem Clausius-Rankine-Kreisprozess, dem Ericsson-Prozess oder nach dem Stirling-Prozess arbeiten. Dabei wird ein Arbeitsmedium abwechselnd bei einer gewissen Temperatur komprimiert und bei einer gewissen anderen Temperatur expandiert, wobei es Wärmemengen abgibt oder aufnimmt. Insbesondere kann beim Clausius-Rankine-Prozess dabei auch ein Phasenübergang des Mediums zwischen flüssig und gasförmig auftreten, beim Stirling-Prozess und beim Ericsson-Prozess bleibt das Arbeitsmedium üblicherweise gasförmig, wobei auch Ausführungsformen mit zumindest teilweiser Phasenänderung existieren. Zur Umwandlung von Wärmemengen bei gewissen Temperaturen in Wärmemengen bei gewissen anderen Temperaturen wird auch der Vuilleumier-Prozess genutzt. Auch andere Wirkprinzipen wie Adsorptions- oder Absorptions-Wärmepumpen gehören zum Stand der Technik.

Stirlingmaschinen und Maschinen, die den Clausius-Rankine-Kreisprozess oder den Ericsson-Prozess umsetzen, haben heute den Nachteil, dass ihre Herstellungskosten im Verhältnis zu den damit umwandelbaren Energiemengen oft nicht wirtschaftlich sind. Weiterhin haben sie meist Wirkungsgrade, die bedingt durch die technische Umsetzung weit schlechter sind als der ideale Carnot-Wirkungsgrad für Wärmekraftmaschinen bzw. Wärmepumpen. Dies hat unter anderem die folgenden Gründe:
1. Die Expansion und/oder Kompression des verwendeten Arbeitsmediums findet weitgehend adiabatisch und nicht isotherm statt
2. Die Wärmetauscherflächen sind zu klein oder die Kopplung der zu-/abgeführten Wärmemengen an das Arbeitsmedium nicht ausreichend, um einen Wärmeübergang zu gewährleisten, der das Arbeitsgas in der verfügbaren Zeit weit genug erwärmt/abkühlt.
3. In Stirlingmaschinen existieren Toträume, so dass sich das Arbeitsgas während der Expansion oder Kompression nicht vollständig in den vorgesehenen Expansions- bzw. Kompressionsvolumina befindet
4. Beim Betrieb entstehen mechanische Reibungsverluste oder strömungsmechanische Reibungsverluste

Im Patent EP 2 657 497 B1 wird ein thermoelektrischer Wandler beschrieben, der die ersten drei der oben genannten Probleme weitgehend löst, indem er Wärmetauscher aufweist, die periodisch in Flüssigkeiten eintauchen. Diese Flüssigkeiten sind an externe Wärmequellen/-senken gekoppelt. Vorteil davon ist, dass dieser thermoelektrische Wandler mit minimalen Toträumen auskommt, dass durch die Lage der Wärmetauscher in den Kompressions-/Expansionsräumen eine nahezu isotherme Kompression/Expansion stattfindet und dass durch vergleichsweise große Wärmetauscherflächen und durch das periodische Eintauchen in die Flüssigkeit ein sehr guter Wärmeübergang zwischen den externen Wärmequellen/-senken und dem Arbeitsmedium gewährleistet ist. Allerdings ist dieser thermoelektrische Wandler in seiner Leistung bzw. Leistungsdichte limitiert: Er kann maximal bei einer Arbeitsfrequenz betrieben werden, bei der das periodische Eintauchen der Wärmetauscherflächen in die Flüssigkeit nicht dazu führt, dass die Flüssigkeit beim Herausziehen der Wärmetauscherflächen teilweise mitgenommen wird und so unkoordiniert im Arbeitsraum "herumspritzt". Diese maximale Arbeitsfrequenz ist v.a. durch die Gewichtskraft der Flüssigkeit und durch die Amplitude der Bewegung der Volumenänderungselemente und Wärmetauscherflächen bestimmt.

Eine deutliche Erhöhung der maximalen Arbeitsfrequenz und damit der Leistung bzw. Leistungsdichte wird durch die Vorrichtung aus DE 10 2018 212 088 B3 ermöglicht. Sie arbeitet nach einem ähnlichen Prinzip, bei dem Volumenbegrenzungselemente und mögliche zusätzliche Wärmetauscherflächen periodisch in eine Flüssigkeit eintauchen, wobei diese Flüssigkeit eine Rotationsbewegung ausführt und so durch Fliehkräfte auch bei höheren Arbeitsfrequenzen am "Herausspritzen" gehindert wird, da die auftretenden Fliehkräfte wesentlich höher sind als die entsprechende Gewichtskraft der Flüssigkeit. Allerdings findet in der in DE 10 2018 212 088 B3 beschriebenen Vorrichtung eine starke Flüssigkeitsströmung statt, die zu hohen strömungsmechanischen Reibungsverlusten führt. Diese wird vor allem verursacht durch die Verdrängung von Flüssigkeit aus den Bereichen zwischen den Schraubenblättern bzw. in diese Bereiche hinein, die u.a. durch die Änderungen des Drucks des Arbeitsmediums verursacht wird. Diese Strömung kann ungehindert stattfinden, da die Flüssigkeit nicht durch Begrenzungselemente daran gehindert wird. Für diese Strömung wird mechanische Energie aus der Drehbewegung der Rotoren aufgebracht, die letztlich in Reibungswärme innerhalb der Flüssigkeit umgesetzt wird und so eine hohe Verlustleistung bedeutet.

### Aufgabe

Die Aufgabe der Erfindung ist es, ein Verfahren und einen thermoelektrischen Wandler zur Verfügung zu stellen, die eine weitgehend isotherme Kompression oder Expansion eines Arbeitsmediums ermöglichen.

### Lösung

Diese Aufgabe wird gelöst durch die Vorrichtung nach Anspruch 1, den thermoelektrischen Wandler nach Anspruch 11 und das computergesteuerte oder elektronisch gesteuerte Verfahren nach Anspruch 14. Weitere Ausführungsformen sind in den Unteransprüchen offenbart.

Die Erfindung betrifft eine Vorrichtung für eine weitgehend isotherme Kompression oder Expansion eines Arbeitsmediums (meist Gas oder Gas mit Flüssigkeitsnebel) - im Gegensatz zu den weit verbreiteten, weitgehend adiabatischen Vorrichtungen für eine Gaskompression oder Gasexpansion wie z.B. Kolbenkompressoren. Zusätzlich zur Kompression oder Expansion des Arbeitsmediums kann auch ein Phasenübergang eines Bestandteils des Arbeitsmediums von gasförmig nach flüssig oder von flüssig nach gasförmig innerhalb der Vorrichtung stattfinden. Durch die isotherme Zustandsänderung des Gases lässt sich so z.B. eine Kompression realisieren, die im Vergleich zu einer adiabatischen Kompression weniger mechanische oder elektrische Energie benötigt. Die bei einer Kompression oder Expansion des Arbeitsmediums auftretende Temperaturänderung kann also sehr schnell ausgeglichen werden, indem das Arbeitsmedium Wärmeenergie an die Flüssigkeit abgibt oder von ihr aufnimmt und so weitgehend konstant auf einer Temperatur gehalten wird, die der der Flüssigkeit entspricht. Mit anderen Worten heißt dies, dass eine Kompression oder Expansion des Arbeitsmediums weitgehend isotherm erfolgen kann.

Eine solche weitgehend isotherme Zustandsänderung eines Gases ist vor allem vorteilhaft bei der Realisierung von thermodynamischen Kreisprozessen wie z.B. dem Stirling-Prozess, dem Ericsson-Prozess oder dem Clausius-Rankine-Prozess, da sich damit höhere Wirkungsgrade als im Falle von weitgehend adiabatischen Zustandsänderungen erzielen lassen. Bei diesen Prozessen durchläuft ein Arbeitsmedium, das zumindest teilweise oder zeitweise gasförmig ist, einen thermodynamischen Kreisprozess, wobei sich sein Druck, seine Temperatur, sein Volumen und andere Zustandsgrößen ändern.

Daher kann die Erfindung in einer Vorrichtung/einem Verfahren zum Umwandeln ...
- ...von Wärmemengen (Wärmequelle und Wärmesenke mit unterschiedlichen Temperaturen) in mechanische/elektrische Energie oder ...
- ... von mechanischer/elektrischer Energie in Wärme und Kälte oder ...
- ... von Wärmemengen mit gewissen Temperaturen in Wärmemengen mit gewissen anderen Temperaturen verwendet werden.

Die Wärme/Kälte kann beispielsweise mittels Flüssigkeiten als Wärmeträger an diesen thermoelektrischen Wandler gekoppelt werden. Daher kann sein Einsatzbereich beispielsweise bei Temperaturen und Drücken liegen, bei denen diese Wärmeträger flüssig sind.

Diese Anwendung kann herkömmliche Wärmepumpen, Wärmekraftmaschinen oder Vorrichtungen zum Umwandeln von (Ab-)Wärme oder Kälte oder Wärmemengen mit gewissen Temperaturunterschieden in Nutzwärme und/oder Nutzkälte ersetzen.

Die Erfindung kann ermöglichen:
- ... hohe Wirkungsgrade. Dies wird erstens erreicht durch die weitgehend isotherme Prozessführung, zweitens durch einen effektiven, direkten Übertrag von Wärmemengen zwischen dem verwendeten Arbeitsmedium und den Flüssigkeiten als Wärmeträger ohne einer zusätzlichen Wärmetauscherwand zwischen den Medien, und drittens durch die Vermeidung von Strömungsverlusten, wie sie bei anderen, weitgehend isothermen Vorrichtungen zur Kompression oder Expansion eines Gases (wie z.B. Flüssigkeitsringpumpen) auftreten.
- ...und durch die Nutzbarkeit kleiner Temperaturunterschiede für den Antrieb der Vorrichtung oder durch die Möglichkeit, auch kleine Temperaturunterschiede in der Funktion als Wärmepumpe effizient erzeugen zu können. Dies ist möglich wegen der direkten Kopplung des in der Maschine verwendeten Arbeitsmediums an die Flüssigkeit als Wärmeträger ohne den Umweg über einen Wärmetauscher.

Weiterhin kann mittels der Erfindung eine Verschleißarmut und ein vergleichsweise einfacher und kostengünstiger Aufbau realisiert werden.

Alternativ kann die isotherme Zustandsänderung auch in anderen Anwendungen verwendet werden, in denen eine weitgehend isotherme Kompression oder Expansion eines Gases oder eines ein Gas enthaltenden Fluids vorteilhaft ist, z.B. als Vakuumpumpe, als Gaskompressor, für Drucklufterzeugung, Kompressions- und Expansionsvorrichtung für Druckluft-Energiespeicher, Expansionsvorrichtung zur Umwandlung eines Gasdrucks in mechanische/elektrische Energie, etc.. Da in der Kompressions- und Expansionsvorrichtung auch ein Phasenübergang von Bestandteilen des Arbeitsgases oder der verwendeten Flüssigkeit stattfinden kann, eignet sie sich auch für Anwendungen wie z.B. Verflüssigung von Gasen (z.B. Erdgas, Stickstoff) oder die Trocknung von Gasen (z.B. Luft).

Die Erfindung betrifft eine Vorrichtung zur Kompression, Expansion, Volumenänderung, Verdrängung eines fluiden Arbeitsmediums, das zumindest teilweise aus Gas besteht. Die Vorrichtung umfasst mindestens ein Volumen, das eine Flüssigkeitsmenge einer Flüssigkeit und ein Teilvolumen mit einem Arbeitsmedium umfasst, und Volumenbegrenzungselemente, die das Volumen begrenzen und die derart ausgebildet sind, dass ein oder mehrere Durchlässe während einer Kompressions-, Expansions- oder Verdrängungsperiode ein Hinausströmen von maximal einer vorgegebenen Teilmenge der Flüssigkeitsmenge ermöglichen. Während der Kompressions-, Expansions- oder Verdrängungsperiode führt die Flüssigkeitsmenge eine Rotation um eine Rotationsachse aus. Die Volumenbegrenzungselemente sind zudem derart ausgebildet, eine ringförmige Strömung der Flüssigkeitsmenge um die Rotationsachse zu unterbinden. Während der Kompressions-, Expansions- oder Verdrängungsperiode ist durch eine Verlagerung mindestens eines der Volumenbegrenzungselemente das Volumen in seiner Gesamtgröße veränderbar.

Das Volumenbegrenzungselement kann das Volumen bis auf den einen oder die mehreren Durchlässe (beispielsweise Spalte oder Öffnungen für den Zu- oder Abtransport des Arbeitsmediums oder der Flüssigkeit) begrenzen. Die Spalte oder Öffnungen können beispielsweise derart bemessen sein oder derart mit anderen Volumina verbunden sein, dass während eines Kompressions- oder Expansionsperiode nur ein sehr geringer Druckverlust dadurch verursacht wird und dass die Flüssigkeit maximal mit der vorgegebenen Teilmenge durch diese Spalte oder Öffnungen aus dem Volumen herausströmt oder in das Volumen hineinströmt (die vorgegebene Teilmenge kann 5% oder 10% oder 15% der Flüssigkeitsmenge im Volumen betragen). Durch den direkten Kontakt des Arbeitsmediums mit der Flüssigkeit kann gewährleistet werden, dass das Arbeitsmedium sehr effektiv thermisch an die Flüssigkeit gekoppelt ist: Wärmemengen müssen nicht zuerst von der Flüssigkeit auf eine Wärmetauscherwand übertragen und dann erst in das Arbeitsmedium oder umgekehrt übertragen werden. Die bei einer Kompression oder Expansion des Arbeitsmediums auftretende Temperaturänderung kann also sehr schnell ausgeglichen werden, indem das Arbeitsmedium Wärmeenergie an die Flüssigkeit abgibt oder von ihr aufnimmt und so weitgehend konstant auf einer Temperatur gehalten wird, die der der Flüssigkeit entspricht. Mit anderen Worten heißt dies, dass eine Kompression oder Expansion des Arbeitsmediums weitgehend isotherm erfolgen kann. Die Flüssigkeit hat eine Funktion als "Wärmeträger", indem kleine Mengen von ihr durch kleine Öffnungen aus dem Volumen entwichen können, um die entstandene Wärme oder Kälte aus dem Volumen abzutransportieren und sie außerhalb der Vorrichtung nutzen zu können oder an ein Wärmereservoir abzugeben. Ebenso kann durch eine weitere oder dieselbe Öffnung Flüssigkeit in das Volumen eintreten, um Wärme oder Kälte in das Volumen hinein zu transportieren und um die ausgetretene Flüssigkeitsmenge zu ersetzen. Diese Öffnungen wie auch andere Öffnungen oder Spalte sind so klein bemessen, dass die Flüssigkeit nur mit einem erheblichen Strömungswiderstand und nur sehr langsam hindurchfließen kann, sich also dadurch der Druck im Volumen nur unwesentlich ändert und auch nur sehr geringe Strömungsverluste (Reibungsverluste durch die Strömung der Flüssigkeit) auftreten.

Beispielsweise kann die Vorrichtung verwendet werden zur weitgehend isothermen Kompression eines Gases, um dieses in einem Druckbehälter bei Überdruck einzuleiten. Dabei muss in die Vorrichtung mechanische oder elektrische Energie eingebracht werden. Das unter Überdruck stehende Gas kann dann in umgekehrter Richtung wieder aus dem Druckbehälter dazu genutzt werden, über die Vorrichtung weitgehend isotherm expandiert zu werden. Dadurch wird mechanische oder elektrische Energie frei, die anderweitig genutzt werden kann. Ein solches Verfahren kann also als Energiespeicher genutzt werden, bei dem die Energie in Form des Überdrucks des Gases im Druckbehälter gespeichert wird. Im Gegensatz zur Verwendung von Vorrichtungen, die das Gas weitgehend adiabatisch komprimieren, lassen sich mit der hier beschriebenen Vorrichtung in einer solchen Anwendung hohe Wirkungsgrade eines solchen Energiespeichers erzielen. Bei dieser Ausführungsform kann das Gas über Druckventile oder Öffnungen, die je nach Lage der Volumenbegrenzungselemente geöffnet oder geschlossen sind, in die Vorrichtung ein- und ausströmen.

Auch bei der Verwendung der hier beschriebenen Vorrichtung zur Erzeugung von Druckluft oder zur Kompression eines Gases oder zur Erzeugung eines Unterdrucks oder Vakuums lassen sich durch die isotherme Prozessführung hohe Wirkungsgrade erreichen.

Die Vorrichtung kann mindestens zwei der Volumina umfassen, die jeweils mindestens ein Teilvolumen des Arbeitsmediums und Flüssigkeitsmengen umfassen kann, wobei die mindestens zwei Volumina jeweils von den Volumenbegrenzungselementen begrenzt sein können, so dass sich die Flüssigkeitsmengen verschiedener Volumina bis maximal auf die vorgegebene Teilmenge nicht vermischen können.

Die vorgegebene Teilmenge kann 5% oder 10% oder 15% betragen. Die vorgegebene Teilmenge kann 5% oder 10% oder 15% der Flüssigkeitsmenge im Volumen betragen.

Die Volumenbegrenzungselemente, die das Volumen des Arbeitsmediums und der Flüssigkeit bis auf kleine Spalte oder Öffnungen oder Aus-/Eintrittsöffnungen vollständig umschließen, verhindern im Gegensatz zu herkömmlichen Flüssigkeitsringpumpen oder im Gegensatz zur Vorrichtung aus DE 10 2018 212 088 B3, dass die Flüssigkeit auf Grund des sich ändernden Drucks im Arbeitsmedium verdrängt wird bzw. in Strömung versetzt wird, wodurch Energie aufgebracht werden müsste, die letztlich durch Reibungsverluste in der strömenden Flüssigkeit in Reibungswärme umgesetzt würde und so eine Verlustleistung bedeuten würde.

Mindestens ein erstes Volumenbegrenzungselement der Volumenbegrenzungselemente kann eine Rotationsbewegung in einem Gehäuse ausführen, das das mindestens eine Volumen umfassen kann, wobei eine Rotationsachse des ersten Volumenbegrenzungselements verschieden von einer Mittelachse des Gehäuses sein kann und/oder das mindestens ein erstes Volumenbegrenzungselement der Volumenbegrenzungselemente kann eine erste Rotationsbewegung ausführen und mindestens ein zweites Volumenbegrenzungselement kann eine zweite Rotationsbewegung ausführen, wobei eine erste Rotationsachse der ersten Rotationsbewegung und eine zweite Rotationsachse der zweiten Rotationsbewegung verschieden voneinander sein können. Das Gehäuse kann kreiszylinderförmig oder andersartig geformt sein.

Ein erstes Volumenbegrenzungselement der Volumenbegrenzungselemente kann eine Rotationsbewegung ausführen, wobei dieses erste Volumenbegrenzungselement bewegliche Begrenzungselemente umfassen kann, die während der Rotation des ersten Volumenbegrenzungselements ihre Lage relativ zu dem ersten Volumenbegrenzungselement periodisch ändern können.

Ein erstes Volumenbegrenzungselement der Volumenbegrenzungselemente kann eine Bewegung ausführen, die eine Rotationsbewegung um eine erste Achse und eine Rotationsbewegung um eine zweite Achse umfassen kann.

Mindestens ein erstes Volumenbegrenzungselement der Volumenbegrenzungselemente kann einen Kolben oder Hohlkolben umfassen, der eine Rotationsbewegung ausführen kann, die von einer periodischen Translationsbewegung überlagert sein kann.

Neben der Funktion als Wärmeträger kann die Flüssigkeit noch eine Dichtfunktion erfüllen, in dem sie das zumindest teilweise gasförmige Arbeitsmedium daran hindert, durch Spalte oder Öffnungen ungewollt aus dem Volumen zu entweichen. Spalte oder Öffnungen sind also bevorzugt von der Flüssigkeit umgeben und nicht vom Arbeitsmedium.

Die Funktion der Vorrichtung, das Arbeitsmedium zu expandieren, zu komprimieren, im Volumen zu ändern oder zu verdrängen, wird dadurch bewerkstelligt, dass sich die Volumenbegrenzungselemente in ihrer Lage relativ zur Flüssigkeit verlagern (oder die Flüssigkeit relativ zu den Volumenbegrenzungselementen), sodass sich das Teilvolumen ändert, das das Arbeitsmedium enthält (dieses Teilvolumen ist einerseits von den Volumenbegrenzungselementen und andererseits von der Flüssigkeit begrenzt). Dabei ist das Arbeitsmedium kontinuierlich in Kontakt mit der Flüssigkeit und entsprechend thermisch an sie gekoppelt, so dass die Kompression, Expansion, Volumenänderung oder Verdrängung weitgehend isotherm erfolgt.

Um zu verhindern, dass die Flüssigkeit bei der Bewegung relativ zu den Volumenbegrenzungselementen von diesen mitgerissen wird und sich in größeren Mengen mit dem Arbeitsmedium vermischen würde oder so Strömungsverluste verursachen würde, muss die Kraft, die die Flüssigkeit in ihrer bevorzugten Lage hält, mindestens größer sein als die Kräfte, die die Flüssigkeit aus ihrer bevorzugten Lage heraustrennen würde. In einer Vorrichtung wie in EP 2 657 497 B1 beschrieben, ist diese Kraft die Erdanziehungskraft. In diesem Fall muss die Erdbeschleunigung mindestens größer sein als die maximale Beschleunigung der Bewegung der Volumenbegrenzungselemente relativ zur Flüssigkeit. Um die vorliegende Erfindung auch mit höheren Geschwindigkeiten (bzw. Arbeitsfrequenzen der periodischen Bewegungen) und damit höheren Maximalbeschleunigungen der Relativbewegung der Volumenänderungselemente relativ zur Flüssigkeit betreiben zu können, wird die Flüssigkeit in eine Rotationsbewegung versetzt. So wirken neben der Erdanziehungskraft noch zusätzliche, wesentlich größere Fliehkräfte auf die Flüssigkeit, die sie in ihrer bevorzugten Lage halten und ein Heraustransportieren von Teilmengen der Flüssigkeit durch die Bewegung der Volumenbegrenzungselemente relativ zur Flüssigkeit auch bei größeren Geschwindigkeiten dieser Relativbewegung verhindern.

Mindestens eine der Flüssigkeitsmengen kann sich verursacht durch Trägheitskräfte oder durch Bewegung von mindestens einem der Volumenbegrenzungselemente im Volumen relativ zu anderen der Volumenbegrenzungselemente bewegen und dabei eine Größe mindestens eines der Teilvolumen ändern.

Die Vorrichtung kann weiter Wärmeübertragungselemente umfassen, die periodisch in die im Volumen befindliche Flüssigkeit der Flüssigkeitsmenge ein- und wieder heraustauchen, wobei die Wärmeübertragungselemente beispielsweise Platten, Gitter und/oder Stäbe umfassen können. Die Platten, Netze, Gitter oder Stäbe können beispielsweise Metall umfassen.

Ein weiterer Vorteil der hier beschriebenen Vorrichtung kann sein, dass der Wärmeübertrag zwischen dem Arbeitsmedium und der Flüssigkeit schnell und damit effektiv erfolgt im Vergleich zu Vorrichtungen, bei denen die Wärme über einen herkömmlichen Wärmetauscher übertragen wird. Das liegt daran, dass das Arbeitsmedium seinen Temperaturausgleich mit der Flüssigkeit direkt an der Grenzfläche zwischen dem Arbeitsmedium und der Flüssigkeit vollziehen kann, und der entsprechende Übertrag von Wärmemengen nicht indirekt über die Wand eines Wärmetauschers erfolgen muss, bei dem zunächst Wärmemengen vom Arbeitsmedium an den Wärmetauschern erfolgt und im zweiten Schritt vom Wärmetauscher auf die Flüssigkeit (oder umgekehrt). Dieser Vorteil lässt sich durch die Wärmeübertragungselemente verstärken. Während des Eintauschens in die Flüssigkeit sind sie thermisch an diese gekoppelt und nehmen weitgehend die Temperatur der Flüssigkeit an. Während sie aus der Flüssigkeit herausgezogen sind, sind sie dann thermisch an das Arbeitsmedium gekoppelt und es findet ein Temperaturausgleich zwischen ihnen und dem Arbeitsmedium statt. Sie erhöhen so die Kontaktfläche des Arbeitsmediums mit Elementen, die quasi dieselbe Temperatur wie die Flüssigkeit haben, so dass der Übertrag von Wärmemengen und so der Temperaturausgleich beschleunigt wird. Diese Wärmeübertragungselemente können zusätzlich dazu dienen, Strömungen der Flüssigkeitsmengen innerhalb des Volumens zu reduzieren, beispielsweise indem Platten derart angeordnet werden, dass ihre Oberflächen senkrecht zur Strömungsrichtung liegen, die sie reduzieren sollen. So lassen sich beispielsweise Platten derart in den Volumina anordnen, dass ihre Oberflächen weitgehend senkrecht zur Rotationsbewegung der Flüssigkeitsmengen um ihre Rotationsachse angeordnet sind, um ein Hin- und Herschwanken der Flüssigkeitsmengen innerhalb ihres jeweiligen Volumens zu verringern.

Ein Thermoelektrischer Wandler zur Umwandlung von Wärmemengen in mechanische oder elektrische Energie oder zur Umwandlung von mechanischer oder elektrischer Energie in Wärme/Kälte oder zur Umwandlung von Wärmemengen bei ersten Temperaturen in Wärmemengen bei zweiten Temperaturen umfasst mindestens eine Vorrichtung wie weiter oben oder weiter unten beschrieben.

Mit dem thermoelektrischen Wandler kann ein thermodynamischer Kreisprozess realisiert werden, beispielsweise ein Stirling-Prozess, ein Ericsson-Prozess, ein Clausius-Rankine-Prozess oder ein Stirling-Prozess, bei dem zusätzlich zur Kompression und Expansion oder Verdrängung des Arbeitsgases eine Kondensation und/oder Verdampfung eines Bestandteils des Arbeitsmediums oder der Flüssigkeit stattfinden kann.

Thermodynamische Kreisprozesse, bei denen ein Arbeitsmedium eine zyklische Zustandsänderung durchläuft (Änderung des Volumens, des Drucks, der Temperatur, des Aggregatzustands, etc. in einer gewissen Abfolge, die sich zyklisch wiederholt) haben oft einen hohen Wirkungsgrad, wenn gewisse Zustandsänderungen - beispielsweise Kompressions- oder Expansionsvorgänge, weitgehend isotherm anstatt adiabatisch ablaufen. Beispiele für solche Kreisprozesse sind der Stirling-Prozess, der Vuilleumier-Prozess, der Ericsson-Prozess oder der Clausius-Rankine-Prozess. Daher kann sich die hier beschriebene Vorrichtung für die Verwirklichung eines solchen Prozesses mit einem hohen Wirkungsgrad eignen.

Das kreiszylinderförmige oder andersartig geformte Gehäuse kann frei drehbar um die Mittelachse des Gehäuses gelagert sein.

Ein computergesteuertes oder elektronisch gesteuertes Verfahren zum Betreiben eines thermoelektrischen Wandlers, wie weiter oben oder weiter unten beschrieben, ist vorgesehen.

Die Volumenänderungselemente können derart gesteuert werden, dass während einer Kompression des Arbeitsmediums dieses zumindest teilweise kondensiert und während einer anschließenden Expansion verdampft. Das Arbeitsmedium kann während der Kompression auch ganz kondensieren.

Der thermoelektrische Wandler kann mechanische/elektrische Energie in Wärmemengen bei gewissen Temperaturen umwandeln (Funktion als Wärmepumpe), oder kann Wärmemengen bei gewissen Temperaturen in elektrische/mechanische Energie umwandeln (Funktion als Wärmekraftmaschine), oder kann Wärmemengen bei gewissen Temperaturen in Wärmemengen bei gewissen anderen Temperaturen umwandeln (Funktion wie bei Kombination aus Wärmepumpe mit Wärmekraftmaschine oder wie bei Vuilleumiermaschine). Durch die Verwendung der Vorrichtung, wie weiter oben oder weiter unten beschrieben, können so hohe Wirkungsgrade erzielt werden, außerdem ist die effiziente Nutzung oder Erzeugung auch von kleinen Temperaturunterschieden möglich wegen der guten und direkten Kopplung des Arbeitsmediums an die Flüssigkeit als Wärmeträger bzw. Wärmetransportmedium.

Die Funktion eines solchen Verfahrens ist im Folgenden am Beispiel des Stirling-Prozesses in der Funktion als Wärmepumpe erläutert. Das im Verfahren verwendete Arbeitsmedium, hier ein Gas, wird in einem ersten Schritt in einem ersten Volumen weitgehend isotherm komprimiert. Dabei gibt es Wärmemengen an eine erste Flüssigkeitsmenge ab, die sich folglich erwärmt.

In einem zweiten Schritt wird das Arbeitsmedium aus dem Teilvolumen verdrängt, das sich zusammen mit dieser ersten Flüssigkeitsmenge im ersten Volumen befindet. Es strömt über eine (gasdichte) Verbindung in ein zweites Volumen, das eine zweite Flüssigkeitsmenge enthält. Während dieses Strömens in das zweite Volumen nimmt das Arbeitsmedium weitgehend die Temperatur der Flüssigkeit und Volumenbegrenzungselemente des zweiten Volumens an, indem es Wärmemengen an die Wand der Verbindung abgibt oder von ihr aufnimmt. Dieser Temperaturangleich des Arbeitsmediums während des Wechsels von einem Volumen in das andere, der wichtig für das Erreichen eines guten Wirkungsgrads ist, kann verbessert werden, wenn ein sogenannter Regenerator in der Verbindung verwendet wird, der eine möglichst große Oberfläche aufweist, mit der das Arbeitsmedium während des Durchströmens in Kontakt (und so in thermischer Kopplung) stehen kann. Beim Durchströmen des Arbeitsmediums durch den Regenerator gibt dieses in der einen Richtung Wärmemengen an den Regenerator ab, der diese quasi zwischenspeichert. Beim Durchströmen in die andere Richtung nimmt das Arbeitsmedium dann Wärmemengen vom Regenerator wieder auf. Im Regenerator bildet sich folglich über dessen Länge ein Temperaturgradient aus und der Regenerator erreicht auf der den beiden Volumina angrenzenden Seiten jeweils eine Temperatur, die weitgehend der in den Volumina vorherrschenden Temperaturen entspricht.

In einem dritten Schritt wird das Arbeitsmedium im zweiten Volumen weitgehend isotherm expandiert. Dabei nimmt es Wärmemengen aus der Flüssigkeit auf, die sich im zweiten Volumen befindet und hält so seine Temperatur weitgehend konstant auf dem Niveau, das auch weitgehend der Temperatur der Flüssigkeit im zweiten Volumen entspricht.

In einem vierten Schritt wird das Arbeitsmedium aus dem zweiten Volumen verdrängt und strömt über dieselbe Verbindung wie in Schritt Zwei wieder zurück in das erste Volumen, wobei es beim Durchströmen durch die Verbindung und durch den möglichen Regenerator wieder weitgehend die Temperatur annimmt, die im ersten Volumen vorherrscht.

Im Anschluss beginnt der Kreisprozess wieder von vorne beim ersten Schritt. Für diese Funktion als Wärmepumpe muss mechanische Energie aufgebracht werden, um diesen Kreisprozess aufrecht zu erhalten und entsprechende Wärmemengen der einen Flüssigkeit zuzuführen und der anderen Flüssigkeit abzuführen. Diese kann z.B. durch einen elektrischen Antrieb erfolgen.

Dieser Kreisprozess kann auch in umgekehrter Richtung durchlaufen werden, so dass der Stirling-Prozess zur Realisierung einer Wärmekraftmaschine verwendet wird. In diesem Fall findet die Expansion des Arbeitsmediums in einem ersten Volumen in Kontakt mit einer ersten Flüssigkeit statt, und die Kompression des Arbeitsmediums findet in einem zweiten Volumen in Kontakt mit einer zweiten Flüssigkeit statt, wobei die erste Flüssigkeit wärmer als die zweite ist.

Wird das Verfahren der vorliegenden Erfindung in Form des Stirling-Prozesses umgesetzt, so kann es sich dabei um einen Alpha-, Beta- oder Gamma-Stirling-Prozess handeln. Auch bei der Umsetzung in Form eines anderen Kreisprozesses wie z.B. dem Ericsson-Prozess oder dem Clausius-Rankine-Prozess, sind unterschiedliche Varianten der Prozessführung möglich. Im Gegensatz zum Stirling-Prozess findet beim Clausius-Rankine-Prozess auch ein Phasenübergang im Arbeitsmedium statt (Wechsel des Aggregatzustands von gasförmig zu flüssig und umgekehrt). Bei der vorliegenden Erfindung sind auch Mischformen der Prozesse möglich, beispielsweise ein Stirling-Prozess, bei dem ein Teil des Arbeitsmediums während der Kompression und Expansion verdampft bzw. kondensiert.

### Kurze Figurenbeschreibung

Die beigefügten Figuren stellen beispielhaft zum besseren Verständnis und zur Veranschaulichung Aspekte und/oder Ausführungsbeispiele der Erfindung dar. Es zeigt:
Figur 1 eine 3D-Ansicht einer ersten Ausführungsform eines thermodynamischen Wandlers,
Figur 2 einen Längsschnitt der Vorrichtung der Figur 1,
Figur 3 einen Querschnitt (Schnitt A-A) durch die erste Hauptkammer,
Figur 4 einen Querschnitt (Schnitt B-B) durch die zweite Hauptkammer,
Figur 5 eine 3D-Ansicht des ersten Rotors zusammen mit den Verbindungselementen,
Figur 6 eine alternative Ausführungsform des ersten Rotors mit zusätzlichen Wärmetauscherelementen,
Figur 7 eine zweite Ausführungsform eines thermodynamischen Wandlers,
Figur 8 einen ersten Querschnitt (Schnitt A-A) durch die erste Hauptkammer,
Figur 9 einen zweiten Querschnitt (Schnitt B-B) durch die erste Hauptkammer,
Figur 10 eine dreidimensionale Ansicht der Rotoren zusammen mit den gasdurchlässigen Verbindungselementen,
Figur 11 einen Längsschnitt durch eine dritte Ausführungsform eines thermodynamischen Wandlers,
Figur 12 einen ersten Querschnitt (Schnitt A-A) durch die erste Hauptkammer,
Figur 13 einen zweiten Querschnitt (Schnitt B-B) durch die zweite Hauptkammer,
Figur 14 einen Drehkolben einer alternativen Ausführungsform,
Figur 15 den Drehkolben der Figur 14 in einer dreidimensionalen Ansicht,
Figur 16 eine weitere Ausführungsform eines thermodynamischen Wandlers und
Figur 17 eine dreidimensionale Ansicht der Hubkolben, Verdrängerkolben, der Verbindungselemente, des Exzenters und des Kugellagers.

### Ausführliche Figurenbeschreibung

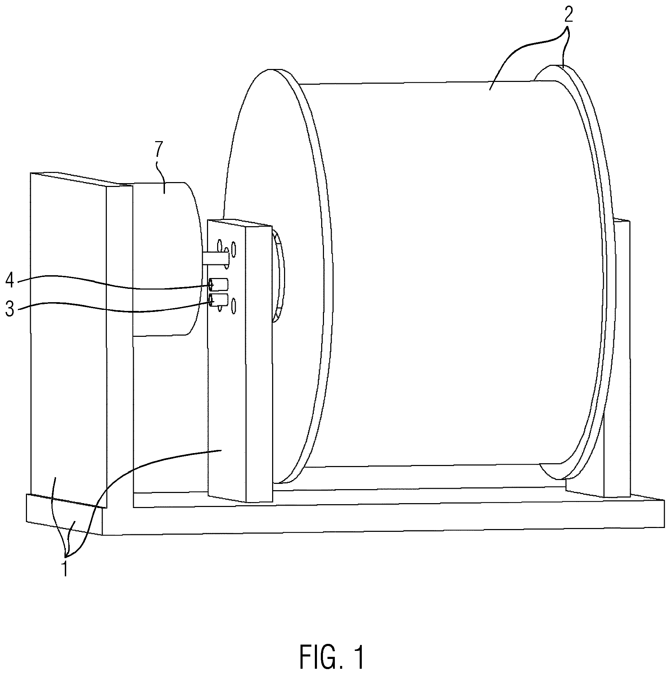

Die Figur 1 zeigt eine 3D-Ansicht einer ersten Ausführungsform eines thermodynamischen Wandlers, der Vorrichtungen zur Kompression, Expansion, Volumenänderung und/oder Verdrängung eines Fluids, das ein Gas enthält, umfasst. Auf einem Gestell 1 ist ein Gehäuse 2 montiert, das über Kugellager (nicht dargestellt) frei drehbar gelagert ist. Durch eine erste Zulaufleitung 3 und eine erste Ablaufleitung 4 kann eine erste Flüssigkeit in das Innere des Gehäuses 2 hineinströmen bzw. wieder herausströmen. Ein Motor 7, der fest mit dem Gestell 1 verbunden ist, kann im Inneren des Gehäuses 2 liegende Rotoren, als erster und zweiter Rotor bezeichnet, antreiben. Alternativ kann der Motor 7 auch als Generator betrieben werden, um mechanische Energie aus der Rotation der Rotoren in elektrische Energie umzuwandeln.

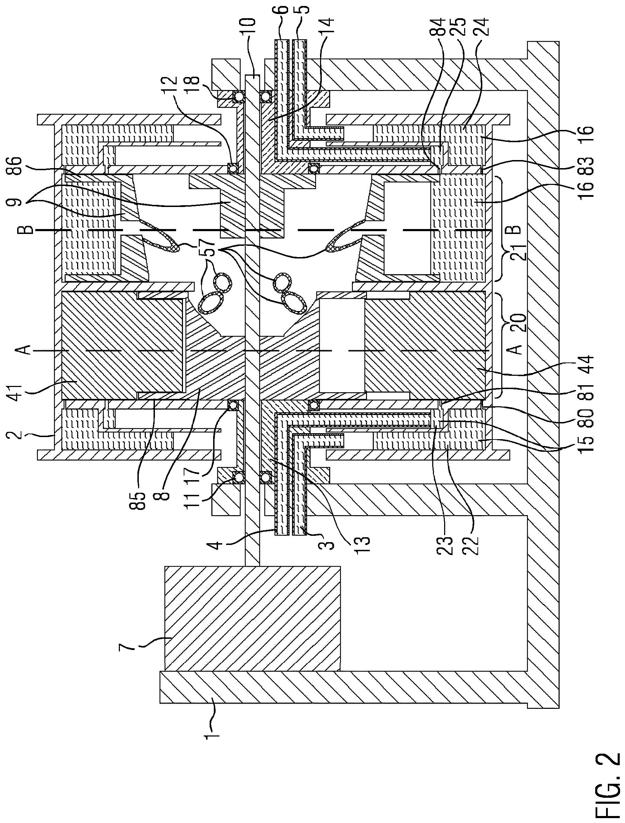

Die Figur 2 zeigt einen Längsschnitt der Vorrichtung der Figur 1. Der Motor 7 ist über eine Achse 10 mechanisch fest mit dem ersten Rotor 8 und dem zweiten Rotor 9 verbunden. Die Achse 10 ist über zwei Kugellager 11, 12 drehbar gelagert. Die Kugellager 11, 12 werden von jeweils einem Lagerbock 13, 14 gehalten, der jeweils fest mit dem Gestell 1 verbunden ist.

Durch eine zweite Zulaufleitung 5 und eine zweite Ablaufleitung 6 kann eine zweite Flüssigkeit 16 in das Innere des Gehäuses 2 hineinströmen bzw. wieder herausströmen. Die Lagerböcke 13, 14 dienen auch zur Aufnahme der ersten bzw. zweiten Zu- und Ablaufleitungen 3, 4, 5, 6 für die erste bzw. zweite Flüssigkeit 15, 16. Im Längsschnitt sind auch die beiden Kugellager 17, 18 dargestellt, über die das Gehäuse 2 drehbar gelagert ist, wobei die Drehachse der Rotoren 8, 9 parallel, aber nicht deckungsgleich zur Drehachse des Gehäuses 2 ist. Die Rotoren 8, 9 sind also exzentrisch zur Drehachse des Gehäuses 2 gelagert. Das Gehäuse 2 ist im Inneren in sechs Kammern 20, 21, 22, 23, 24, 25 unterteilt, die jeweils rotationssymmetrisch sind. In der einen innenliegenden Kammer 20, die auch als erste Hauptkammer 20 bezeichnet wird, befindet sich der exzentrisch zum Gehäuse 2 gelagerte erste Rotor 8 und in der anderen innenliegenden Kammer 21, die auch als zweite Hauptkammer 21 bezeichnet wird, befindet sich der exzentrisch zum Gehäuse 2 gelagerte zweite Rotor 9. Die Rotoren 8, 9 sind nicht mit dem Gehäuse 2 verbunden und können innerhalb der Kammern 20, 21 rotieren.

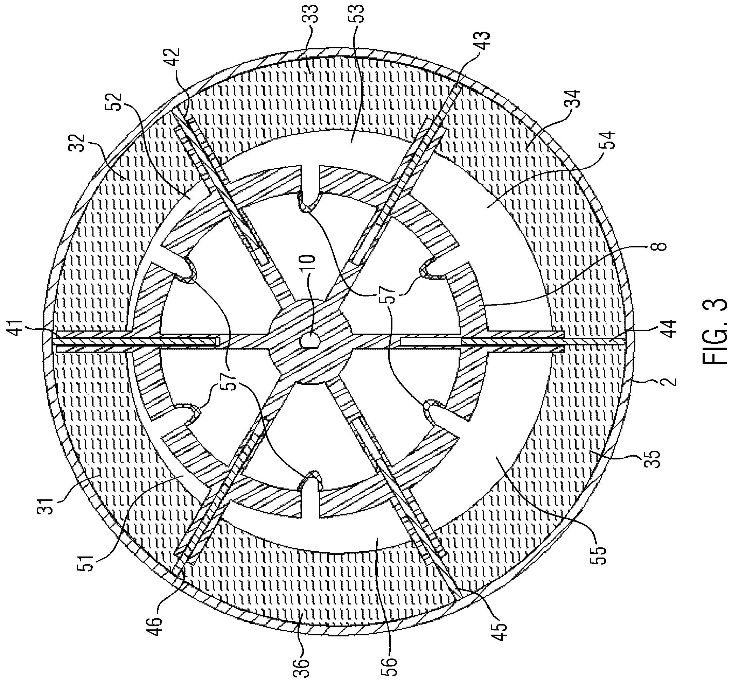

In der ersten Hauptkammer 20 sind bewegliche Begrenzungselemente angeordnet, von denen zwei 41, 44 zu erkennen sind, und deren Funktion in der Figur 3 näher erläutert wird.

In der Figur 2 sind zudem Anschnitte von gasdurchlässigen Verbindungselementen 57 zu erkennen. Die gasdurchlässigen Verbindungselemente 57 verbinden jeweils ein Volumen aus der ersten Hauptkammer 20 ist mit jeweils einem anderen Volumen aus der zweiten Hauptkammer 21.

Über die erste Zulaufleitung 3, die Kammer 22 und erste Öffnungen 80 kann erste Flüssigkeit 15 kontinuierlich in die erste Hauptkammer 20 und damit in deren Volumina (siehe Figur 3) nachflie-ßen und über zweite Öffnungen 81, die Kammer 23 und die erste Ablaufleitung 4 wieder abfließen.

Die zweite Flüssigkeit 16 kann über die zweite Zulaufleitung 5, die Kammer 24 und dritte Öffnungen 83 in die zweite Hauptkammer 21 zufließen und über vierte Öffnungen 84, die Kammer 25 und die zweite Ablaufleitung 6 wieder abfließen.

Die Rotoren 8, 9 haben innenliegend ein konisches Profil, sodass Flüssigkeit, die in das Innere der Rotoren 8, 9 gelangt, über enge, jeweils außenliegende erste bzw. zweite Spalte 85, 86 abfließen kann.

Die Figur 3 zeigt einen Querschnitt (Schnitt A-A) durch die erste Hauptkammer 20, innerhalb derer sich der erste Rotor 8 befindet.

Der erste Rotor 8 unterteilt die erste Hauptkammer 20 in sechs Volumina 31, 32, 33, 34, 35, 36, die jeweils von einem Teil des Gehäuses 2 sowie dem ersten Rotor 8 und relativ zum ersten Rotor8 beweglichen Begrenzungselementen 41, 42, 43, 44, 45, 46 begrenzt sind, die zusammen sogenannte Volumenbegrenzungselemente bilden.

Ein Volumen kann sowohl das Arbeitsmedium (ein Gas, ein Gasgemisch oder ein Gemisch aus Gas(en) mit Flüssigkeitsnebel) als auch eine Flüssigkeit enthalten und durch die Volumenbegrenzungselemente bis auf Spalte oder Öffnungen für den Zu- oder Abtransport des Arbeitsmediums oder der Flüssigkeit begrenzt sein. Diese Spalte oder Öffnungen können derart bemessen oder derart mit anderen Volumina verbunden sein, dass während eines Kompressions- oder Expansionsvorgangs nur ein sehr geringer Druckverlust dadurch verursacht wird, dass die Flüssigkeit durch diese Spalte oder Öffnungen aus dem Volumen herausströmt oder in das Volumen hineinströmt (<10% der Flüssigkeitsmenge im Volumen). Durch den direkten Kontakt des Arbeitsmediums mit der Flüssigkeit ist gewährleistet, dass das Arbeitsmedium sehr effektiv thermisch an die Flüssigkeit gekoppelt ist.

Innerhalb jedes Volumens 31-36 befindet sich jeweils ein Teilvolumen 51, 52, 53, 54, 55, 56, das mit einem Arbeitsmedium (z.B. Luft) gefüllt ist, sowie ein Teil der ersten Flüssigkeit 15. Die erste Flüssigkeit 15 wird durch die Zentrifugalkräfte jeweils nach außen beschleunigt. Die Begrenzungselemente 41-46 werden von Schlitzen im ersten Rotor 8 geführt und sind darin radial frei beweglich. Sobald der erste Rotor 8 mit ausreichender Geschwindigkeit rotiert, werden die Begrenzungselemente 41-46 von der Fliehkraft radial nach außen gedrückt, bis sie die Außenwand des Gehäuses 2 erreichen. So verhindern sie, dass erste Flüssigkeit 15 von einem Volumen (z.B. 31) in ein benachbartes Volumen (z.B. 32) fließen kann.

Alternativ ist auch die Nutzung von Federn o.ä. denkbar, um die Begrenzungselemente 41-46 von innen gegen das Gehäuse 2 zu drücken.

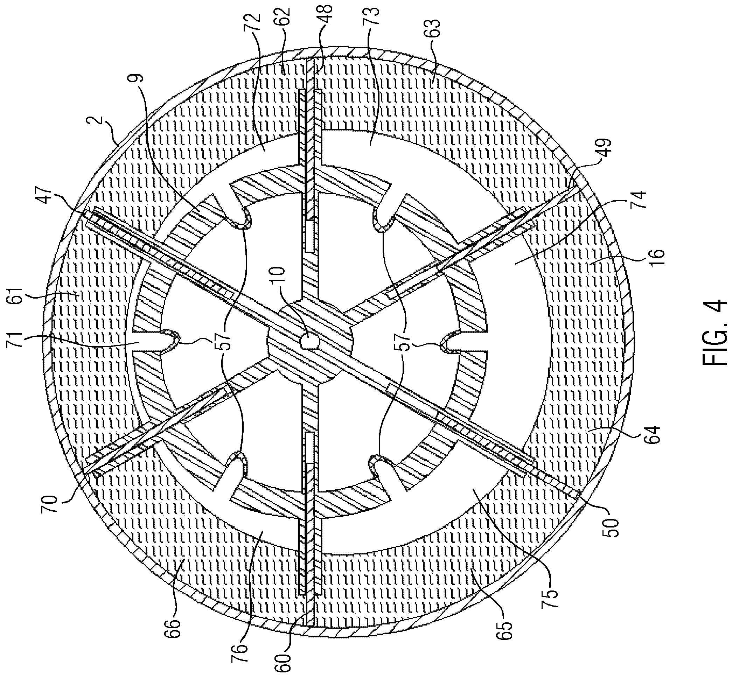

Die Figur 4 zeigt einen Querschnitt (Schnitt B-B) durch die zweite Hauptkammer 21, innerhalb derer sich der zweite Rotor 9 befindet.

Der zweite Rotor 9 in der zweiten Hauptkammer 21 ist identisch zu dem ersten Rotor 8 aufgebaut. Im Vergleich zum ersten Rotor 8 ist der zweite Rotor 9 aber um einen gewissen Winkel gedreht auf der Achse 10 befestigt.

Der zweite Rotor 9 unterteilt die zweite Hauptkammer 21 in sechs Volumina 61, 62, 63, 64, 65, 66, die jeweils von einem Teil des Gehäuses 2 sowie dem zweiten Rotor 9 und relativ zum zweiten Rotor 9 beweglichen Begrenzungselementen 47, 48, 49, 50, 60, 70 begrenzt sind, die zusammen sogenannte Volumenbegrenzungselemente bilden.

Innerhalb jedes Volumens 61-66 befindet sich jeweils ein Teilvolumen 71, 72, 73, 74, 75, 76, das mit einem Arbeitsmedium (z.B. Luft) gefüllt ist, sowie ein Teil der zweiten Flüssigkeit 16. Die zweite Flüssigkeit 16 wird durch die Zentrifugalkräfte jeweils nach außen beschleunigt. Die Begrenzungselemente 47, 48, 49, 50, 60, 70 werden von Schlitzen im zweiten Rotor 9 geführt und sind darin radial frei beweglich. Sobald der zweite Rotor 9 mit ausreichender Geschwindigkeit rotiert, werden die Begrenzungselemente 47, 48, 49, 50, 60, 70 von der Fliehkraft radial nach außen gedrückt, bis die Außenwand des Gehäuses 2 erreichen. So verhindern sie, dass zweite Flüssigkeit 16 von einem Volumen (z.B. 61) in ein benachbartes Volumen (z.B. 62) fließen kann.

Alternativ ist auch die Nutzung von Federn o.ä. denkbar, um die Begrenzungselemente 47, 48, 49, 50, 60, 70 von innen gegen das Gehäuse 2 zu drücken.

Jeweils ein Volumen (z.B. 31) aus der ersten Hauptkammer 20 ist mit jeweils einem Volumen (z.B. 63) aus der zweiten Hauptkammer 21 mittels eines der gasdurchlässigen Verbindungselemente 57 verbunden, sodass durch das Arbeitsmedium aus dem Teilvolumen (z.B. 51) der ersten Hauptkammer 20 in das Teilvolumen (z.B. 73) der zweiten Hauptkammer 21 kontinuierlich ein Druckausgleich stattfindet. Diese Verbindungselemente 57 können mit einem Regeneratormaterial gefüllt sein, z.B. Stahlwolle oder eine anderes Material (bevorzugt Metall), das gasdurchlässig ist und eine große Oberfläche aufweist, damit es sehr schnell Wärmemengen mit dem vorbeiströmenden Fluid austauschen kann.

Anhand von Figur 3 und Figur 4 lässt sich die Umsetzung des Stirling-Kreisprozesses erklären.

Im Folgenden werden nun die vier Schritte des Kreisprozesses anhand der beiden Volumina 31 und 63 der ersten Hauptkammer 20 bzw. der zweiten Hauptkammer 21 erläutert. In den anderen Volumina (32 mit 64, 33 mit 65, 34 mit 66, 35 mit 61, 36 mit 62) läuft der Kreisprozess analog ab, jedoch phasenverschoben im Vergleich zu den Volumina 31 und 63. Es handelt sich hier also um einen sechsfachen Alpha-Stirling-Prozess.

In der in den Figuren 3 und 4 dargestellten Ausgangslage befindet sich das Arbeitsmedium der Volumina 31 und 63 zum größten Teil im Teilvolumen 73; wie in der Figur 3 zu erkennen ist, ist das Teilvolumen 51 klein im Vergleich zum Teilvolumen 73. Wenn sich die beiden Rotoren 8, 9 nun weiter im Uhrzeigersinn drehen (z.B. um 60° bis zur dargestellten Position der Volumina 32 und 64), vergrößert sich die Summe der Teilvolumina 51 und 73. Das Arbeitsmedium wird also expandiert. Dabei kühlt es sich nur kaum ab, da es Wärmeenergie v.a. aus der zweiten Flüssigkeit 16 aufnehmen kann, an die der größte Teil des Arbeitsmediums angrenzt - die Expansion findet also weitgehend isotherm statt. Bei einer weiteren Rotation der Rotoren 8, 9 wird das Teilvolumen 73 verkleinert und das Teilvolumen 51 vergrößert. Das Arbeitsmedium strömt also vom Teilvolumen 73 in das Teilvolumen 51 durch das Verbindungselement 57 und durch den darin befindlichen Regenerator. Dabei nimmt es weitgehend die Temperatur der ersten Flüssigkeit 15 an, auf die die dem Teilvolumen 51 zugewandte Seite des Verbindungselements 57 und des Regenerators vorher erwärmt wurde. Jetzt befindet sich das Teilvolumen 51 etwa an der in Figur 3 dargestellten Position des Teilvolumens 54 und das Teilvolumen 73 an der in Figur 4 dargestellten Position des Teilvolumens 76 und der Großteil des Arbeitsmediums befindet sich in Teilvolumen 51. Bei einer weiteren Drehung der Rotoren 8, 9 im Uhrzeigersinn wird die Summe der Teilvolumina 51 und 73 verkleinert und das Arbeitsmedium wird komprimiert - wieder weitgehend isotherm. Dabei gibt es Wärmemengen v.a. an die erste Flüssigkeit 15 ab, da sich der Großteil des Arbeitsmediums im Volumen 31 befindet und dort thermisch an die erste Flüssigkeit 15 gekoppelt ist. Bei einer weiteren Rotation der Rotoren 8, 9 in die in Figur 3 und Figur 4 dargestellte Ausgangslage wird das Teilvolumen 51 verkleinert und das Teilvolumen 73 vergrößert, sodass das Arbeitsmedium wieder durch das Verbindungselement 57 und den Regenerator in das Teilvolumen 73 strömt und dabei weitgehend die Temperatur der zweiten Flüssigkeit 16 annimmt.

Bei diesem Prozess wird also die erste Flüssigkeit 15 erwärmt und die zweite Flüssigkeit 16 abgekühlt. Für die Kompression muss über die Rotation der Rotoren 8, 9 dabei mechanische Energie aufgewendet werden, wodurch die Rotoren gebremst werden, und durch die Expansion werden die Rotoren 8, 9 angetrieben und so beschleunigt.

Sofern die zweite Flüssigkeit 16 wärmer ist als die erste Flüssigkeit 15, werden die Rotoren durch die Expansion des Arbeitsmediums stärker beschleunigt als sie durch die Kompression des Arbeitsmediums gebremst werden. Sofern diese Energiedifferenz größer ist als die mechanische Reibung im System inkl. der Strömungsverluste der Flüssigkeiten kann damit der Motor 7 angetrieben werden und elektrische Energie erzeugen.

Falls die erste Flüssigkeit 15 wärmer ist als die zweite Flüssigkeit 16 muss der Motor 7 mechanische Energie aufbringen, um die Rotoren 8, 9 anzutreiben - dadurch kann aber die erste Flüssigkeit 15 weiter erwärmt werden und die zweite Flüssigkeit 16 weiter abgekühlt werden, sodass das Verfahren wie eine Wärmepumpe arbeitet. Über die erste Zulaufleitung 3, die Kammer 22 und die Öffnungen 80 (siehe Fig. 2) kann erste Flüssigkeit 15 kontinuierlich in die erste Hauptkammer 20 und damit in die Volumina 31-36 nachfließen und über die Öffnungen 81, die Kammer 23 und die erste Ablaufleitung 4 wieder abfließen. Dabei bilden sich in den Kammern 22 und 23 jeweils Flüssigkeitsringe aus. Ebenso kann die zweite Flüssigkeit 16 über die zweite Zulaufleitung 5, die Kammer 24 und die Öffnungen 83 in die zweite Hauptkammer 21 zufließen und über die Öffnungen 84, die Kammer 25 und die zweite Ablaufleitung 6 wieder abfließen, wobei sich hier in den Kammern 24 und 25 Flüssigkeitsringe ausbilden. So kann die Kopplung der ersten und zweiten Flüssigkeiten 15, 16 an externe Wärmereservoirs erfolgen bzw. Nutzwärme und Nutzkälte aus dem System herausgeführt werden oder Antriebswärme und Antriebskälte dem System zugefügt werden. Über die Länge der erste und zweiten Ablaufleitungen 4, 6 wird dabei die Höhe der Flüssigkeitsringe in den Kammern 23 und 25 geregelt und damit auch die Höhe der rotierenden Flüssigkeitsmengen in den Volumina 31-36 der ersten Hauptkammer 20 sowie den Volumina 61-66 der zweiten Hauptkammer 21. Da die Rotoren 8, 9 innenliegend das konische Profil aufweisen, kann Flüssigkeit, die in das Innere der Rotoren 8, 9 gelangt, über die engen, jeweils außenliegenden Spalte 85, 86 abfließen. Das Gehäuse 2 ist über die Kugellager 17, 18 drehbar gelagert, sodass es sich während des Betriebs mitdrehen kann. So wird die Bewegung des Gehäuses 2 relativ zu den Rotoren 8, 9, zu den ersten und zweiten Flüssigkeiten 15, 16 und zu den beweglichen Begrenzungselementen 41-46, 47, 48, 49, 50, 60, 70 minimiert und entsprechend werden Reibungsverluste minimiert.

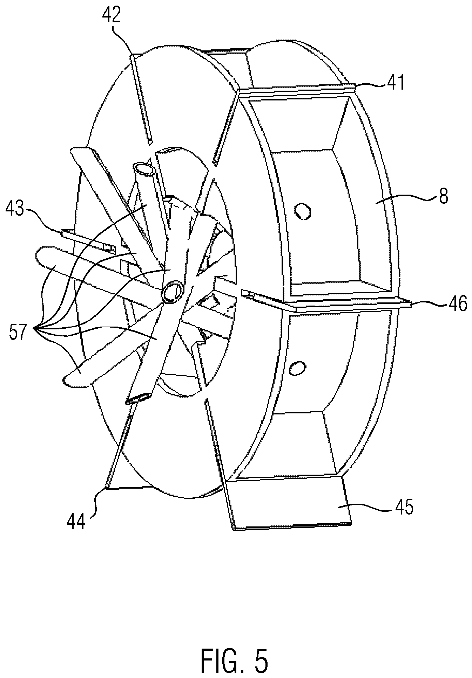

Die Figur 5 zeigt eine dreidimensionale Schrägansicht des ersten Rotors 8 zusammen mit den Verbindungselementen 57, die die Teilvolumina 51-56 der ersten Hauptkammer 20 jeweils mit den Teilvolumina 71, 72, 73, 74, 75, 76 der zweiten Hauptkammer verbinden und ein Regeneratormaterial enthalten können. Die beweglichen Begrenzungselemente 41-46 des ersten Rotors 8 sind auch zu erkennen. Die Verbindungselemente 57 können derart vorgesehen sein, dass folgende Zuordnung der Teilvolumina zustande kommt: 51 mit 73, 52 mit 74, 53 mit 75, 54 mit 76, 55 mit 71, 56 mit 72.

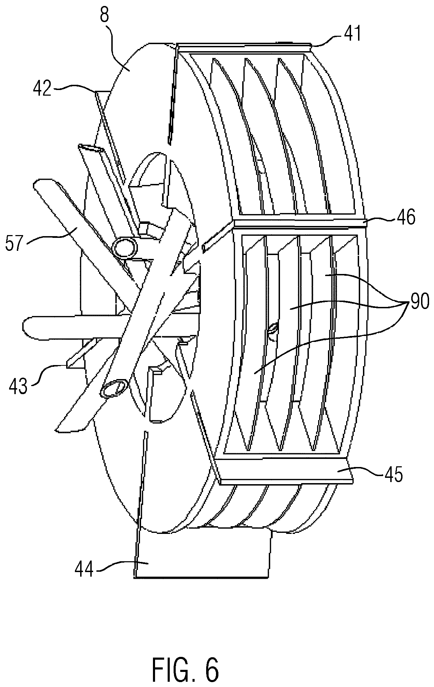

Die Figur 6 zeigt eine alternative Ausführungsform des ersten Rotors 8, der die gleichen Elemente wie in der Figur 5 umfasst und bei dem zusätzliche Wärmetauscherelemente 90 vorgesehen sind, die während der Rotation des ersten Rotors 8 unterschiedlich tief in die erste Flüssigkeit 15 eintauchen, d.h. es gibt Bereiche von ihnen, die sich zu gewissen Zeiten innerhalb der ersten Flüssigkeit 15 befinden und zu anderen Zeiten außerhalb der ersten Flüssigkeit 15 und somit innerhalb des Arbeitsmediums in einem der Teilvolumina 51-56. Während die Wärmetauscherelemente 90 in die erste Flüssigkeit 15 eintauchen, sind sie thermisch an sie gekoppelt und können weitgehend die Temperatur der ersten Flüssigkeit 15 annehmen. Während die Wärmetauscherelemente 90 nicht in die erste Flüssigkeit 15 eintauchen, sind sie thermisch an das Arbeitsmedium gekoppelt und können ihre Temperatur weitgehend auf dieses übertragen. So tragen diese zusätzlichen Wärmetauscherelemente 90 dazu bei, den Austausch von Wärmemengen zwischen dem Arbeitsmedium und der ersten Flüssigkeit 15 zu verbessern bzw. zu beschleunigen.

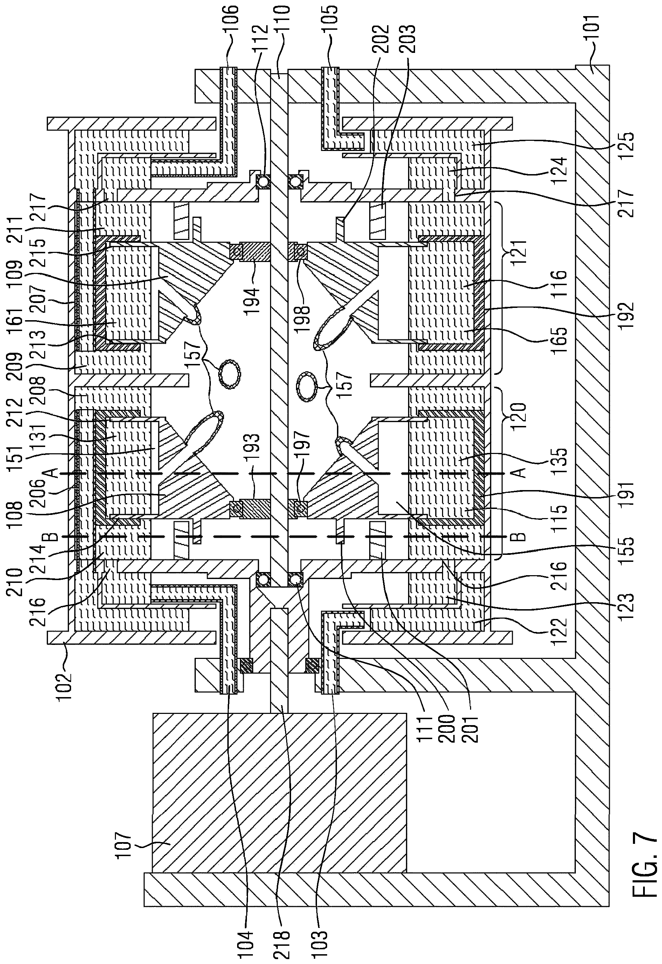

Die Figur 7 zeigt einen Längsschnitt einer zweiten Ausführungsform eines thermodynamischen Wandlers, der Vorrichtungen zur Kompression, Expansion, Volumenänderung und/oder Verdrängung eines Fluids, das ein Gas enthält, umfasst.

Auf einem Gestell 101 ist ein Gehäuse 102 montiert, das über Kugellager 111, 112 frei drehbar und konzentrisch zur Achse 110 gelagert ist. Ein Motor 107, der fest mit dem Gestell 101 verbunden ist, kann das Gehäuse 102 und im Inneren des Gehäuses 102 liegende Rotoren 108, 109, als erster und zweiter Rotor 108, 109 bezeichnet, antreiben. Alternativ kann der Motor 107 auch als Generator betrieben werden, um mechanische Energie aus der Rotation der Rotoren 108, 109 in elektrische Energie umzuwandeln.

Die Achse 110 ist fest und nicht drehbar mit dem Gestell 101 verbunden. Auf dieser Achse 110 sind fest zwei Exzenter 193, 194 montiert, die dafür sorgen, dass die Kugellager 197, 198 eine zur Achse 110 exzentrische Position haben. Über diese beiden Kugellager 197, 198 sind die beiden Rotoren 108, 109 drehbar gelagert, so dass sie eine Rotationsbewegung exzentrisch zur Achse 110 und damit auch exzentrisch zum Gehäuse 102 ausführen können.

Über Zahnräder 200, 202, die fest mit den Rotoren 108, 109 verbunden sind und über Innenzahnräder 201, 203, die fest mit dem Gehäuse 102 verbunden sind, sind die Rotoren 108, 109 mechanisch derart mit dem Gehäuse 102 gekoppelt, dass die Rotationsgeschwindigkeiten der Rotoren 108, 109 in einem festen Verhältnis zur Rotationsgeschwindigkeit des Gehäuses 102 stehen.

Die Drehachse 218 des Motors 107 ist fest mit dem Gehäuse 102 verbunden und kann dieses in Rotation versetzen oder Rotationsenergie von ihm aufnehmen, um sie in elektrische Energie umzuwandeln. Über die Zahnräder 200, 202 und die Innenzahnräder 201, 203 ist die Rotationsbewegung der Drehachse 218 des Motors 107 indirekt auch an die Rotationsbewegung der Rotoren 108, 109 gekoppelt.

Durch eine erste Zulaufleitung 103 und eine erste Ablaufleitung 104 kann eine erste Flüssigkeit 115 in das Innere des Gehäuses 102 hineinströmen bzw. wieder herausströmen. Durch eine zweite Zulaufleitung 105 und eine zweite Ablaufleitung 106 kann eine zweite Flüssigkeit 116 in das Innere des Gehäuses 102 hineinströmen bzw. wieder herausströmen.

Das Gehäuse 102 ist im Inneren in sechs Kammern 120, 121, 122, 123, 124, 125 unterteilt, die jeweils rotationssymmetrisch sind. In der einen innenliegenden Kammer 120, die auch als erste Hauptkammer 120 bezeichnet wird, befindet sich der exzentrisch zum Gehäuse 102 gelagerte erste Rotor 108 und in der anderen innenliegenden Kammer 121, die auch als zweite Hauptkammer 121 bezeichnet wird, befindet sich der exzentrisch zum Gehäuse 102 gelagerte zweite Rotor 109. Die Rotoren 108, 109 sind nicht mit dem Gehäuse 102 verbunden und können innerhalb der Kammern 120, 121 rotieren.

In der Figur 7 sind zudem Anschnitte von gasdurchlässigen Verbindungselementen 157 zu erkennen. Die gasdurchlässigen Verbindungselemente 157 verbinden jeweils ein Volumen aus der ersten Hauptkammer 120 ist mit jeweils einem anderen Volumen aus der zweiten Hauptkammer 121. Zwei Volumina 131, 135 der insgesamt sechs Volumina und zwei Teilvolumina 151, 155 der ersten Hauptkammer 120 und zwei Volumina 161, 165 der zweiten Hauptkammer 121 sind dargestellt.

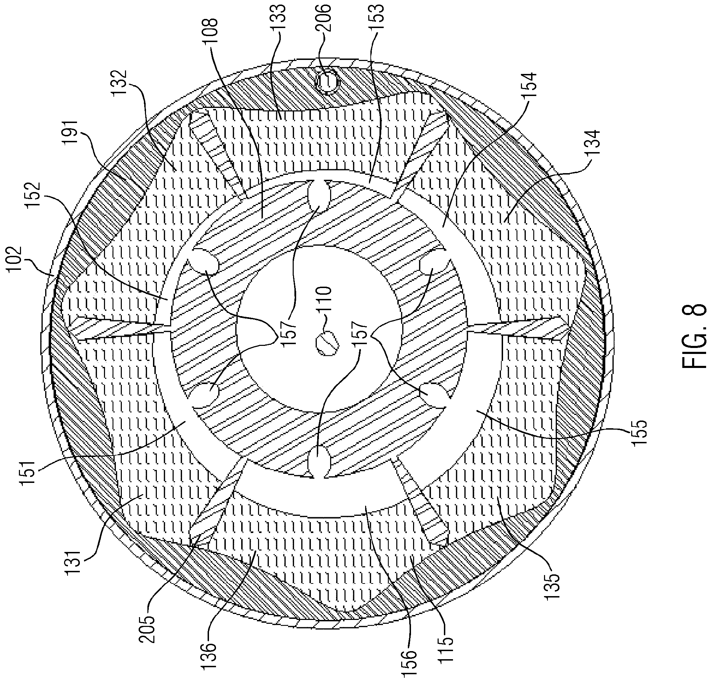

Die Strömung der ersten Flüssigkeit 115 durch die Vorrichtung erfolgt in dieser zweiten Ausführungsform durch die Zulaufleitung 104 in die Kammer 122 und von dort über eine erste Leitung 206 in eine Kammer 208 der ersten Hauptkammer 120. Von dort gelangt sie mit einem gewissen Strömungswiderstand über einen Spalt 212 in die Volumina der ersten Hauptkammer 120 (siehe Figur 8), wo sie während des Betriebs erwärmt oder abgekühlt wird. Über einen Spalt 214 kann die erste Flüssigkeit 115 die Volumina der ersten Hauptkammer 120 wieder verlassen und gelangt in die Kammer 210, dann durch eine Öffnung 216 in die Kammer 123, in der sie einen Flüssigkeitsring bildet. Von dort kann sie über die erste Ablaufleitung 104 die Vorrichtung wieder verlassen, wobei die erste Ablaufleitung 104 mit ihrer Länge in radialer Richtung definiert, bis zu welcher Höhe sich der Wasserring in den Kammern 123 und 210 ausbildet, an die sich auch die Füllstände der ersten Flüssigkeit 115 in den Volumina der ersten Hauptkammer 120 angleichen.

In gleicher Weise fließt die zweite Flüssigkeit 116 durch die Vorrichtung über die zweite Zulaufleitung 105, die Kammer 124, eine zweite Leitung 207, eine Kammer 209 der zweiten Hauptkammer 121. Von dort gelangt die zweite Flüssigkeit 116 mit einem gewissen Strömungswiderstand über einen Spalt 213 in die Volumina der zweiten Hauptkammer 121. Über einen Spalt 215 kann die zweite Flüssigkeit 216 die Volumina der zweiten Hauptkammer 121 wieder verlassen und gelangt in die Kammer 211, dann durch Öffnungen 217 in die Kammer 125 und verlässt die Vorrichtung durch die zweite Ablaufleitung 106.

Die Figur 8 zeigt einen ersten Querschnitt (Schnitt A-A) durch die erste Hauptkammer 120. Die Volumina 131, 132, 133, 134, 135, 136, in denen sich die das Arbeitsmedium enthaltenden Teilvolumina 151, 152, 153, 154, 155, 156 befinden, werden von dem ersten Rotor 108 und dem äußeren Begrenzungselement 191 als Volumenbegrenzungselemente gebildet. Das äußere Begrenzungselement 191 ist fest mit dem Gehäuse 102 verbunden und befindet sich zusammen mit dem ersten Rotor 108 in der ersten Hauptkammer 120. Der Querschnitt der ersten Leitung 206 ist zu sehen.

Das äußere Begrenzungselement 191 ist derart geformt, dass die sternförmig vom ersten Rotor 108 nach außen abstehenden Elemente mit dem Begrenzungselement 191 dabei immer nur einen sehr feinen Spalt 205 bilden, durch den nur sehr geringe Mengen der ersten Flüssigkeit 115 pro Zeiteinheit fließen können und so während des Betriebs nur ein sehr geringer Flüssigkeitsaustausch bzw. Druckausgleich zwischen benachbarten Volumina (z.B. 131 und 132) stattfinden kann.

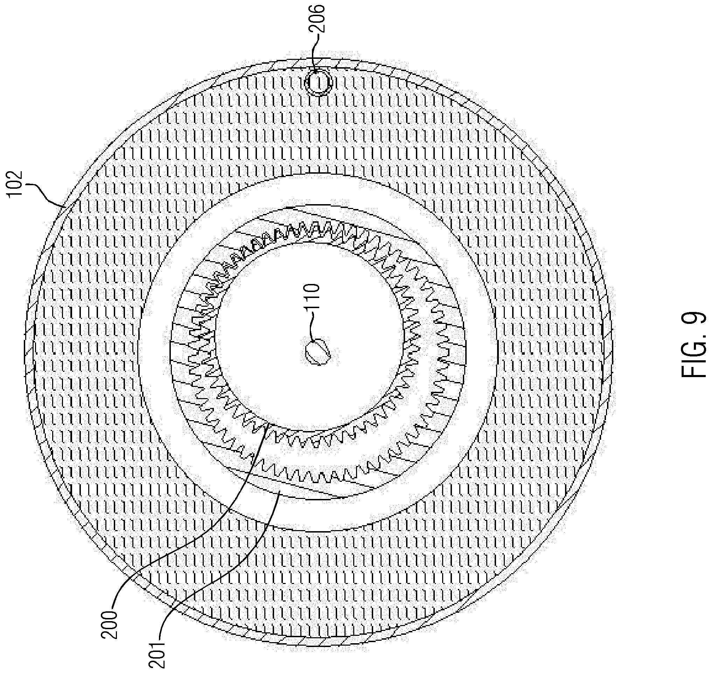

Die Figur 9 zeigt einen zweiten Querschnitt (Schnitt B-B) durch die erste Hauptkammer 120. Es ist zu erkennen, wie das Zahnrad 200, das fest mit dem ersten Rotor 108 verbunden ist, und das Innenzahnrad 201, das fest mit dem Gehäuse 102 verbunden ist, ineinander greifen, wodurch der erste Rotor 108 mechanisch derart mit dem Gehäuse 102 gekoppelt ist, dass die Rotationsgeschwindigkeit des ersten Rotors 108 in einem festen Verhältnis zur Rotationsgeschwindigkeit des Gehäuses 102 steht.

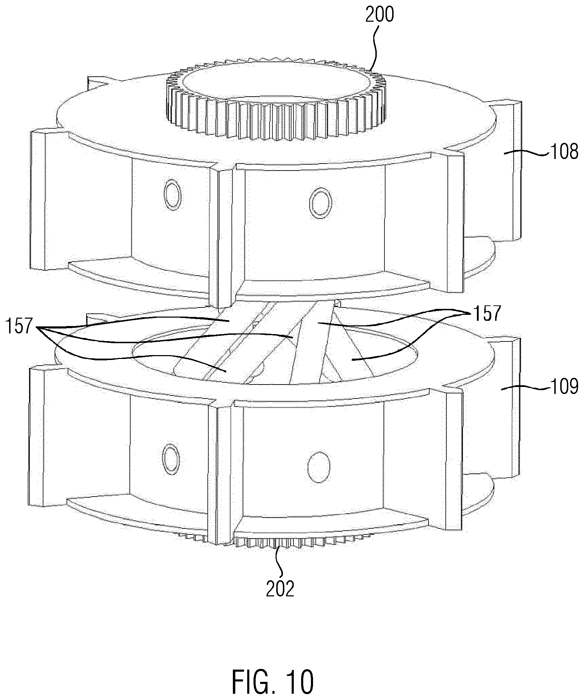

Die Figur 10 zeigt eine dreidimensionale Ansicht der Rotoren 108, 109 zusammen mit den gasdurchlässigen Verbindungselementen 157, über die das Arbeitsmedium aus den Teilvolumina 151, 152, 153, 154, 155, 156 des ersten Rotors 108 in jeweils eines der Teilvolumina des zweiten Rotors 109 strömen kann und umgekehrt. Dabei kann das Arbeitsmedium über die Wand der Verbindungselemente 157 oder zusätzlich über ein im Verbindungselement 157 befindlichen Regenerator seine Temperatur ändern. Dargestellt sind auch das Zahnrad 200, das fest mit dem ersten Rotor 108 verbunden ist und das Zahnrad 202, das fest mit dem zweiten Rotor 109 verbunden ist. Die Rotoren 108, 109 weisen jeweils auf beiden Seiten senkrecht zu ihrer Rotationsachse kreisförmige Volumenbegrenzungselemente auf, die verhindern, dass das Arbeitsmedium seitlich entweichen kann.

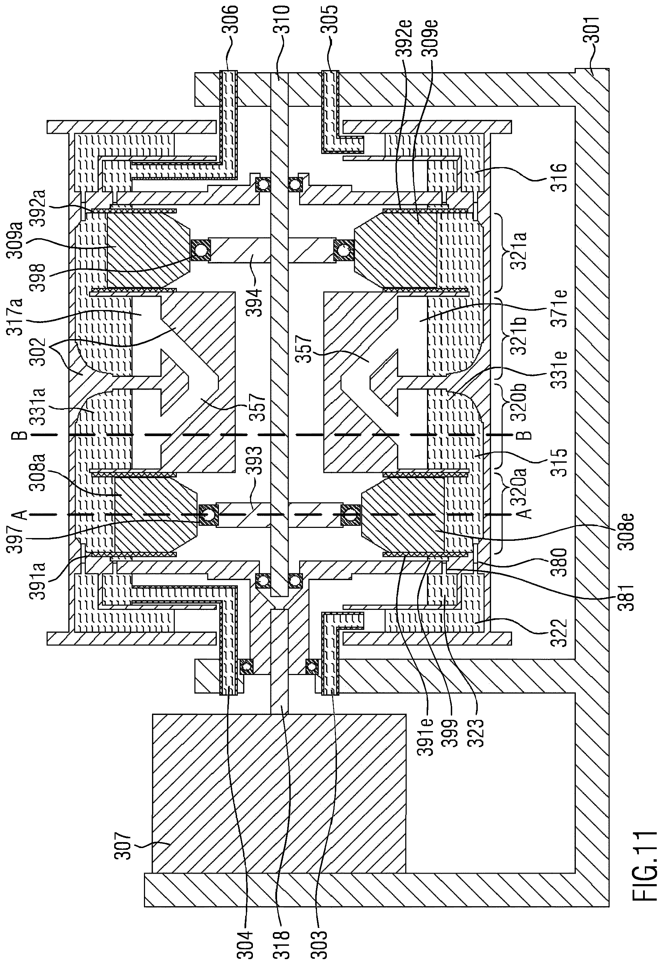

Eine dritte Ausführungsform einer Vorrichtung zur Kompression, Expansion, Volumenänderung und/oder Verdrängung eines Fluids, das ein Gas enthält, ist in den Figuren 11, 12 und 13 dargestellt.

Die Figur 11 zeigt einen Längsschnitt durch eine dritte Ausführungsform eines thermodynamischen Wandlers, der Vorrichtungen zur Kompression, Expansion, Volumenänderung und/oder Verdrängung eines Fluids, das ein Gas enthält, umfasst.

Die mit Arbeitsmedium und der ersten Flüssigkeit 315 gefüllten acht Volumina (zwei davon, nämlich 331a, 331e, sind in der Darstellung zu erkennen) befinden sich hier in der ersten Hauptkammer 320a und der zweiten Hauptkammer 320b des Gehäuses 302. Die mit Arbeitsmedium und der zweiten Flüssigkeit 316 gefüllten acht Volumina (zwei davon, nämlich 371a, 371e, sind in der Darstellung zu erkennen) befinden sich hier in der dritten Hauptkammer 321a und der vierten Hauptkammer 321b des Gehäuses 302.

Die Exzenter 393, 394 sind fest mit der feststehenden Achse 310 verbunden, die fest mit dem Gestell 301 verbunden ist.

Auf dem Exzenter 393 ist das Kugellager 397 befestigt, das die Lage von acht Kolben (zwei davon, nämlich 308a, 308e, sind in der Darstellung zu erkennen) in der ersten Hauptkammer 320a begrenzt, indem es diese durch Berührung daran hindert, sich weiter ins Innere der Vorrichtung zu bewegen. Auf dem Exzenter 394 ist das Kugellager 398 befestigt, das die Lage von sechs Kolben (zwei davon, nämlich 309a, 309e, sind in der Darstellung zu erkennen) in der dritten Hauptkammer 321a begrenzt, indem es diese durch Berührung daran hindert, sich weiter ins Innere der Vorrichtung zu bewegen.

Da alle der sechzehn Kolben (308a, 308e, 309a, 309e) eine geringere Dichte haben als die erste bzw. zweite Flüssigkeit 315, 316, "schwimmen" sie auf der entsprechenden Flüssigkeit 315, 316, so dass sie in der Regel auch immer die entsprechenden Kugellager 397, 398 berühren. Die Drehachse 318 des Motors 307 ist fest mit dem drehbar gelagerten Gehäuse 302 verbunden und kann dies in Rotation versetzen oder abbremsen.

Die erste Hauptkammer 320a umfasst zudem acht Zylinder (zwei davon, nämlich 391a, 391e, sind in der Darstellung zu erkennen). Auch die dritte Hauptkammer 321a umfasst acht Zylinder (zwei davon, nämlich 392a, 392e, sind in der Darstellung zu erkennen).

Die erste Flüssigkeit 315 kann durch eine erste Zuleitung 303 in die erste und zweite Hauptkammer 320a, 320b und durch eine erste Ablaufleitung 304 daraus ausgebracht werden.

Die zweite Flüssigkeit 316 kann durch eine zweite Zuleitung 305 in die dritte und vierte Hauptkammer 321a, 321b und durch eine zweite Ablaufleitung 306 daraus ausgebracht werden.

Die acht Volumina 331a, 331e der zweiten Hauptkammer 320b können jeweils mittels gasdurchlässigen Verbindungselementen 357 mit den sechs Volumen 371a, 371e der vierten Hauptkammer 321b verbunden sein.

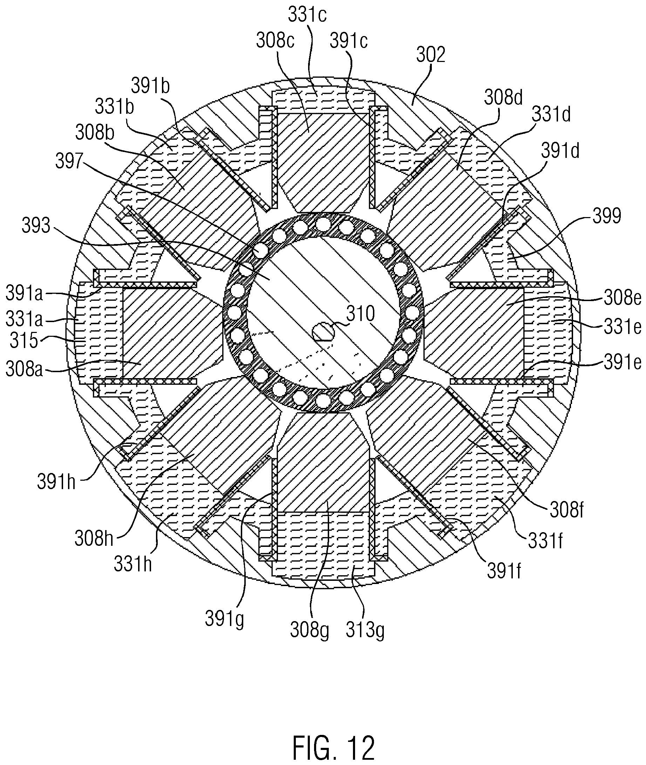

Die Figur 12 zeigt einen Querschnitt (Schnitt A-A) durch die erste Hauptkammer 320a, die die Volumina 331a, 331b, 331c, 331d, 331e, 331f, 331g, 331h mit Arbeitsmedium und erster Flüssigkeit 315 umfasst.

Der erste Exzenter 393, auf dem das Kugellager 397 befestigt ist, ist fest mit der Achse 310 verbunden. Das Kugellager 397 begrenzt die Lage der Kolben 308a, 308b, 308c, 308d, 308e, 308f, 308g, 308h, indem es diese durch Berührung daran hindern, sich weiter ins Innere der Maschine zu bewegen.

Rotiert das Gehäuse 302, dann rotieren auch die Zylinder 391a, 391b, 391c, 391d, 391e, 391f, 391g, 391h, da sie fest mit dem Gehäuse 302 verbunden sind. In den Zylindern 391a-391h können sich die Kolben 308a-308h in radialer Richtung frei bewegen und ihre Lage ist dabei jeweils von dem auf dem Exzenter 393 befestigten Kugellager 397 definiert. Während einer vollständigen Rotation des Gehäuses 302 um 360° vollziehen die Kolben 308a-308h folglich neben ihrer Rotationsbewegung um die Rotationsachse 310 des Gehäuses 302 zusätzlich jeweils eine Periode einer oszillierenden Bewegung in radialer Richtung. Zusammen mit dem Gehäuse 302 und den Zylindern 391a-391h bilden die Kolben 308a-308h die Volumenbegrenzungselemente der Volumina 331a-331h, die jeweils Arbeitsmedium und erste Flüssigkeit 315 enthalten.

Wird in einem Volumen (z.B. 331a) der Kolben (z.B. 308a) durch die Rotation des Gehäuses 302 radial nach außen gedrückt, so verdrängt er auf diese Weise die Flüssigkeit (z.B. 315) im Volumen (z.B. 331a) in Richtung der weiter innen liegenden Hauptkammer (z.B. 320b), so dass diese das an sie angrenzende Arbeitsmedium aus dem Volumen (z.B. 331a) verdrängt in das mit ihm über das Verbindungselement 357 verbundene Volumen (z.B. 371a) und/oder das Arbeitsmedium komprimiert. Das Verbindungselement 357 kann ein Regeneratormaterial enthalten. Sofern die beiden Exzenter 393, 394 durch ihre Lage eine passende Phasenverschiebung jeweils zwischen den beiden Kolben (z.B. 308a und 309a) verursachen, die zwei Volumina begrenzen, die jeweils über ein Verbindungselement 357 miteinander verbunden sind, so lässt sich mit dieser Ausführungsform wieder ein Alpha-Stirling-Kreisprozess in der Anwendung als Wärmepumpe oder als Wärmekraftmaschine realisieren.

Die erste Flüssigkeit 315 durchläuft die Maschine durch die erste Zulaufleitung 303, durch die Kammer 322, durch die Öffnungen 380, durch die Volumina 331a-331h, angetrieben durch den Überdruck in den Volumina 331a-331h durch die Spalte zwischen den Kolben 308a-308h und den Zylindern 391a-391h, durch den Innenraum 399 der Hauptkammer 320a, durch die Öffnungen 381, durch die Kammer 323 und durch die erste Ablaufleitung 304. Die zweite Flüssigkeit 316 fließt analog durch die Vorrichtung.

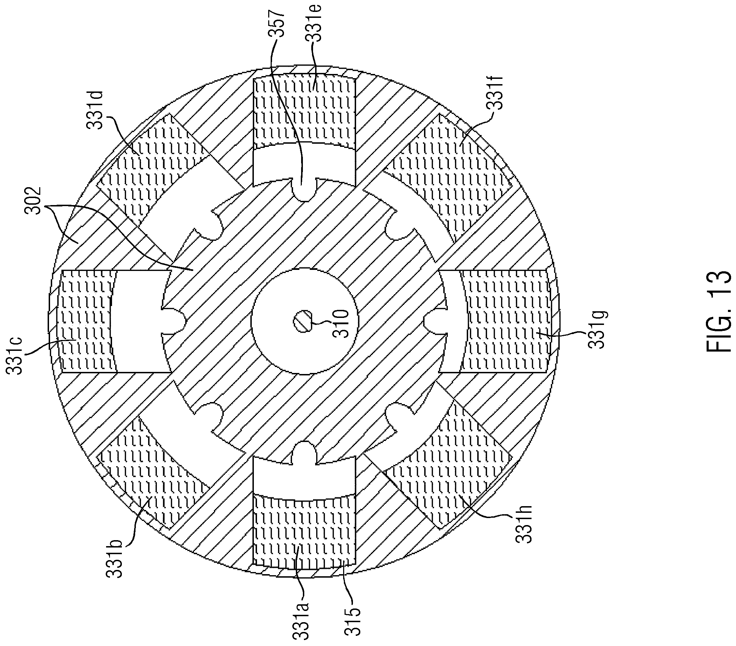

Die Figur 13 zeigt einen Querschnitt (Schnitt B-B) durch die zweite Hauptkammer 320b, die die Volumina 331a-331h mit Arbeitsmedium und erster Flüssigkeit 315 umfasst. Zudem sind Teile des Gehäuses 302 dargestellt, in denen die Volumina 331a-331h angeordnet sind.

In der Figur 13 sind zudem Anschnitte von gasdurchlässigen Verbindungselementen 357 zu erkennen, die jeweils ein Volumen 331a-331h aus der ersten und zweiten Hauptkammer 320a, 320b jeweils mit einem Volumen aus der dritten und vierte Hauptkammer 321a, 321b verbinden. Beispielsweise können die Volumina 331a und 371a durch ein Verbindungselement 357 verbunden sein.

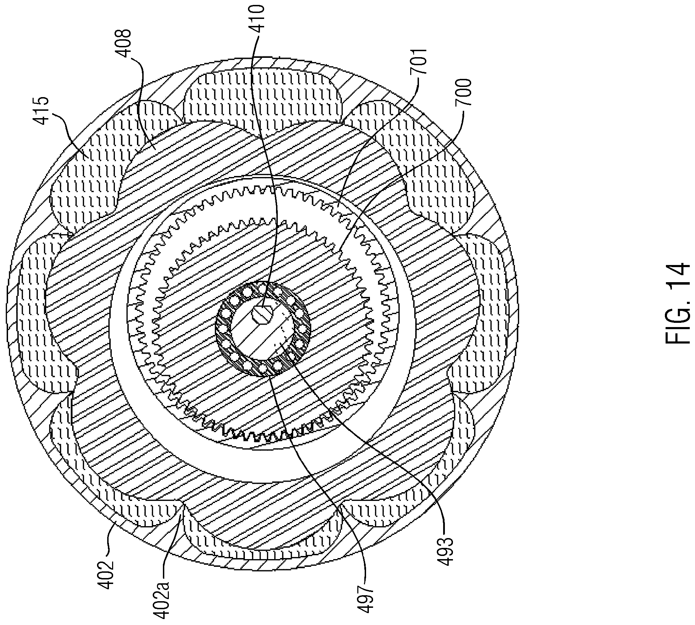

Wie in der Figur 14 dargestellt, können in einer alternativen Ausführungsform die in der Figur 11 in der ersten Hauptkammer 320a und der dritten Hauptkammer 321a vorgesehenen Elemente, die die Funktion haben, die erste und zweite Flüssigkeit 315, 316 periodisch in Richtung der zweiten Hauptkammer 320b und der vierten Hauptkammer 321b hinein bzw. heraus zu verschieben, ersetzt werden durch einen Drehkolben 408. Der Drehkolben 408 führt eine Rotation um eine Drehachse aus, die durch den Mittelpunkt des Kugellagers 497 geht, über das er drehbar gelagert ist. Die Drehachse des Drehkolbens 408 ist exzentrisch zur Drehachse des Gehäuses 402, die der Lage der feststehenden Achse 410 entspricht. Die Lage der beiden Rotationsachsen zueinander wird dabei durch den Exzenter 493 definiert, auf dem der Drehkolben 408 über das Kugellager 497 drehbar gelagert ist. Über das in den Drehkolben 408 integrierte Zahnrad 700 sowie über das Innenzahnrad 701, das fest mit dem Gehäuse 402 verbunden ist, wird analog zur zweiten Ausführungsform aus der Figur 7 gewährleistet, dass die Rotationsgeschwindigkeiten dieser beiden Rotationen des Gehäuses 402 und des Drehkolbens 408 ein konstantes Verhältnis zueinander haben. So lässt sich gewährleisten, dass der Drehkolben 408 die oben beschriebene periodische Verschiebung der ersten Flüssigkeit 415 verursacht, wobei die Spalte zwischen den fest mit dem Gehäuse 402 verbundenen Dichtungselementen 402a und dem Drehkolben 408 stets sehr klein bleiben. Über zusätzliche Dichtleisten, die beweglich an den Spitzen der Dichtungselemente 402a befestigt sind und mittels Federn oder ähnlicher kraftverursachender Elemente gegen den Drehkolben 408 gedrückt werden, lässt sich die Spaltbreite zwischen den Dichtungselementen 402a und dem Drehkolben 408 noch zusätzlich verringern und entsprechend die Dichtwirkung verbessern.

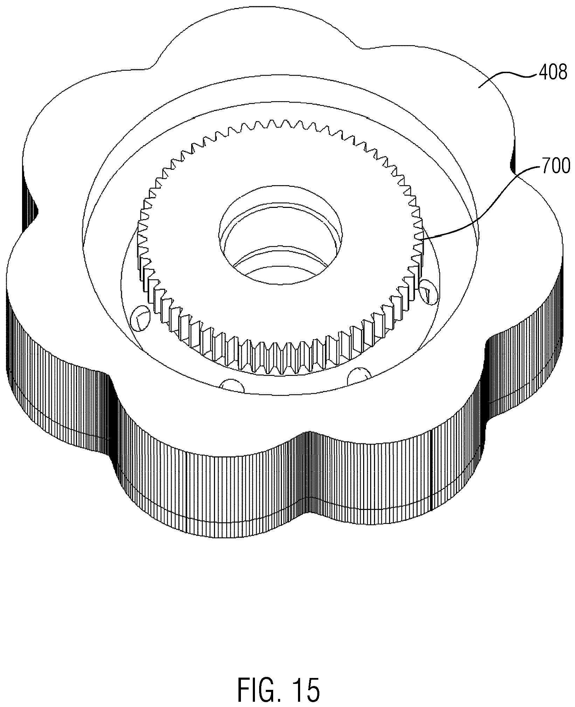

Die Figur 15 zeigt den Drehkolben 408 mit dem Innenzahnrad 700 in einer dreidimensionalen Ansicht.

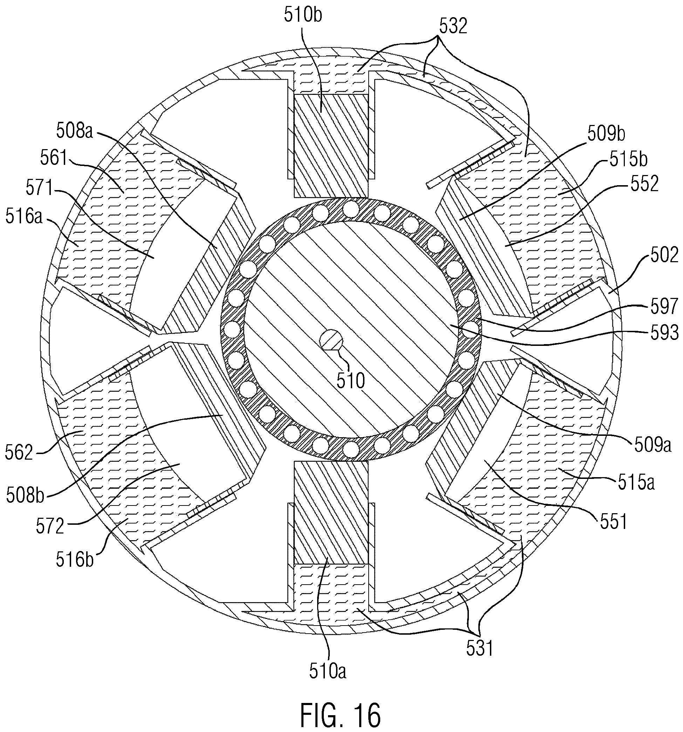

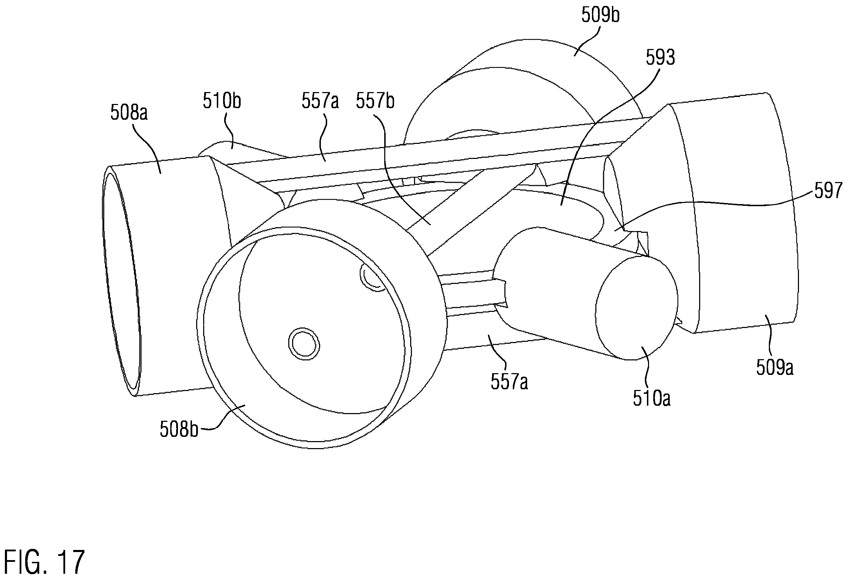

Die Figuren 16 und 17 zeigen eine weitere Ausführungsform eines thermodynamischen Wandlers, der Vorrichtungen zur Kompression, Expansion, Volumenänderung und/oder Verdrängung eines Fluids, das ein Gas enthält, umfasst. Im Gegensatz zu den in den Figuren 1 bis 15 dargestellten Ausführungsformen wird mit dieser weitern Ausführungsform ein Stirling-Prozess in der Variante als Beta-Stirling-Prozess verwirklicht.

Die in dem Querschnitt der Figur 16 gezeigte Ausführungsform enthält eine Achse 510, die fest mit einem äußeren, feststehenden Gestell verbunden und nicht drehbar ist. Ein Exzenter 593 ist fest mit der Achse 510 verbunden, sodass er auch ortsfest ist. Auf dem Exzenter 593 sitzt ein Kugellager 597, das die Bewegung von Hohlkolben 508a, 508b, 509a, 509b und von Verdichterkolben 510a, 510b radial nach innen begrenzt. Die Hohlkolben 508a, 508b, 509a, 509b haben die Funktion eines "Verdrängerkolbens" und die Verdichterkolben 510a, 510b die Funktion eines "Arbeitskolbens", was die bei Beta-Stirling-Maschinen üblichen Begriffe sind.

In dieser weiteren Ausführungsform ist die Drehachse eines Motors fest mit dem drehbar gelagerten Gehäuse 502 verbunden und kann dessen Rotationsbewegung beschleunigen oder abbremsen. Die Rotationsachse des Gehäuses 502 entspricht der Lage der feststehenden Achse 510. Die Verdichterkolben 510a, 510b haben eine geringere Dichte als die im Gehäuse 502 enthaltenen Flüssigkeiten 515a, 515b, 516a, 516b, die bei Rotation des Gehäuses 502 durch die Zentrifugalkraft radial nach außen gedrückt werden. Daher "schwimmen" die Verdichterkolben 510a, 510b auf der Flüssigkeit 515a, 515b und werden von ihr radial nach innen verdrängt, bis diese Bewegung durch den auf dem Exzenter 593 gelagerten Kugellager 597 begrenzt wird. Die jeweils radial gegenüberliegenden Hohlkolben 508a, 508b, 509a, 509b sind über gasdurchlässige Verbindungselemente (siehe Figur 17) miteinander verbunden, sodass je ein Hohlkolben, der vom Kugellager 597 radial nach außen gedrückt wird den ihn gegenüberliegenden Hohlkolben dadurch mit nach innen zieht.

Die Volumina 531, 532, 561, 562 werden begrenzt durch die folgenden Volumenbegrenzungselemente: das Gehäuse 502, das in radialer Richtung nach innen sechs Zylinder bildet, und die in den Zylindern beweglich angeordneten Hohlkolben 508a, 508b, 509a, 509b und Verdrängerkolben 510a, 510b. Innerhalb dieser Volumina 531, 532, 561, 562 befinden sich auch die mit dem Arbeitsmedium gefüllten Teilvolumina 551, 571, die von den Flüssigkeiten 515a, 515b, 516a, 516b, den Hohlkolben 508a, 508b, 509a, 509b, den Verdichterkolben 510a, 510b und den Verbindungselementen begrenzt werden.

Die mit dem Arbeitsmedium gefüllten Teilvolumina 551, 571 sind mit zwei gasdurchlässigen Verbindungselementen miteinander verbunden, wobei die Verbindungselemente ein Regeneratormaterial enthalten können. Durch die durch die Rotation des Gehäuses verursachte Bewegung der Hohlkolben 508a, 509a werden die Teilvolumina 551, 571 abwechselnd verkleinert und vergrößert, wobei ein Teilvolumen (z.B. 551) besonders klein ist, wenn das ihm radial gegenüberliegende Teilvolumen (z.B. 571) besonders groß ist und umgekehrt. Je nach Rotationsrichtung des Gehäuses 502 bildet das Teilvolumen 551 den Expansionsraum eines Beta-Stirling-Prozesses und das Teilvolumen 571 den Kompressionsraum (oder umgekehrt). Dabei wird das Arbeitsmedium abwechseln zwischen den beiden Teilvolumina 551, 571 hin- und herbewegt, wobei es die Verbindungselemente durchströmt. Innerhalb der Teilvolumina 551, 571 ist das Arbeitsmedium jeweils thermisch an eine der Flüssigkeiten 515a, 516b gekoppelt und kann Wärmemengen von diesen aufnehmen oder an sie abgeben. Während des Strömens durch die Verbindungselemente kann es derart erwärmt oder abgekühlt werden, dass es beim Eintreten in die Teilvolumina 551, 571 bereits weitgehend deren Temperatur angenommen hat.

Der Verdrängerkolben 510a führt ebenfalls eine periodische Bewegung in radialer Richtung aus. Dabei verdrängt er die Flüssigkeit 515a derart, dass das Teilvolumen 551 verkleinert oder vergrößert wird. Dadurch ändert sich der Druck in den Teilvolumina 551, 571, wodurch die Kompression und Expansion des Arbeitsgases und folglich dessen Temperaturänderung verursacht wird. Diese Temperaturänderung erfolgt allerdings nur in geringem Maße, da die Teilvolumina 551, 571 thermisch an die Flüssigkeiten 515a bzw. 516a gekoppelt sind und Wärmemengen an diese abgeben können oder von ihnen aufnehmen können und so kontinuierlich ihre Temperatur an die der Flüssigkeiten 515a bzw. 516a anpassen. Durch die Positionierung des Verdrängerkolbens 510a kann die Phasenverschiebung dessen radialer, sinusförmiger Bewegung im Vergleich zur radialen, sinusförmigen Bewegung der Hubkolben 508a und 508b definiert werden. Im dargestellten Fall beträgt die Phasenverschiebung zwischen dem Verdrängerkolben 510a und dem Hohlkolben 509a 60°. In einer weiteren bevorzugten Ausführungsform beträgt diese Phasenverschiebung 90°, wobei die Verdrängerkolben 510a, 510b nicht in der gleichen Ebene senkrecht zur Achse (510) liegen müssen wie die Hubkolben 508a, 508b, 509a, 509b. Die Teilvolumina 552, 572 bilden in analoger Weise einen Beta-Stirling-Prozess, wobei die Druckänderung in diesem Fall durch die radiale Bewegung des Verdrängerkolbens 510b verursacht wird.

Die Figur 17 zeigt eine dreidimensionale Ansicht der Hubkolben 508a, 508b, 509a, 509b, der Verdrängerkolben 510a, 510b, der Verbindungselemente 557a, 557b, des Exzenters 593 und des Kugellagers 597.

Durch diese Anordnung können in der Figur 16 beispielsweise die radial gegenüberliegenden Hohlkolben 508a, 509a über das gasdurchlässige Verbindungselement 557b und die radial gegenüberliegenden Hohlkolben 508b, 509b über das gasdurchlässige Verbindungselement 557a miteinander verbunden sein. Somit sind beispielsweise die mit dem Arbeitsmedium gefüllten Teilvolumina 551, 571 durch das gasdurchlässige Verbindungselement 557b miteinander verbunden.

Weitere Ausführungsformen, bei denen die Expansion und Kompression eines Arbeitsmediums durch eine durch Trägheitskräfte in Schwingung versetzte, rotierende Flüssigkeitsmenge verursacht werden, sind möglich. So kann eine Flüssigkeitsmenge z.B. durch Variation von Fliehkräften durch eine periodisch schwankende Rotationsgeschwindigkeit in Schwingung versetzt werden. Auch ist es möglich, der Rotationsgeschwindigkeit eine weitere periodische Bewegung zu überlagern, z.B. eine Rotation um eine andere Achse, wodurch eine rotierende Flüssigkeitsmenge in eine Schwingungsbewegung versetzt wird.

Eine weitere Ausführungsform ist dadurch gegeben, dass bei der in den Figuren 7 bis 10 dargestellten Ausführungsformen die feststehende Achse (z.B. 110) ersetzt wird durch eine mit einer gewissen Geschwindigkeit rotierende Achse. So kann erreicht werden, dass die Rotation des Gehäuses (z.B. 102) höher ist im Vergleich zur Frequenz des realisierten Stirling-Prozesses als in der in den Figuren 7 bis 10 dargestellten Ausführungsformen. So kann die Zentrifugalkraft, die die Flüssigkeitsmengen von innen gegen die äußere Wand des Gehäuses (z.B. 102) drücken weiter erhöht werden, ohne gleichzeitig die Frequenz des Stirling-Prozesses zu erhöhen. Dies ist analog auch bei der Ausführungsform aus den Figuren 11 bis 13, aus der Ausführungsform aus den Figuren 14 und 15 oder bei der Ausführungsform aus den Figuren 16 und 17 möglich.

Neben den hier genannten bevorzugten Ausführungsformen eines Stirling-Prozesses, die in der Funktion als Wärmepumpe oder Wärmekraftmaschine betrieben werden können, besteht eine bevorzugte Ausführungsform auch darin, je eine dieser Ausführungsformen, die als Wärmekraftmaschine arbeitet, mit einer anderen Ausführungsform mechanisch zu koppeln, die als Wärmepumpe arbeitet. So lässt sich damit aus der Nutzung einer Temperaturdifferenz zweier verschiedener Wärmereservoirs (z.B. Umgebungswärme oder Abwärme eines industriellen Prozesses und eine geeignete Wärmesenke) Nutzwärme und/oder Nutzkälte erzeugen. Dies ist mit der hier vorliegenden Erfindung erstrebenswert, da sie durch die effektive Kopplung des Arbeitsmediums an die Flüssigkeit als Wärmeträger auch die Nutzung geringer Temperaturdifferenzen in einer solchen Anwendung erlaubt und so auch Abwärme oder Umgebungswärme nutzbar macht, die nur geringe Temperaturunterschiede zu einer vorliegenden Wärmesenke hat.

## Patentansprüche

1. Vorrichtung zur Kompression, Expansion, Volumenänderung, Verdrängung eines fluiden Arbeitsmediums, das zumindest teilweise aus Gas besteht, wobei die Vorrichtung umfasst:
- mindestens ein Volumen, das eine Flüssigkeitsmenge einer Flüssigkeit (15, 16, 115, 116, 315, 316, 415, 515a, 515b, 516a, 516b, 615, 616a, 616b) und ein Teilvolumen mit einem Arbeitsmedium umfasst,
- Volumenbegrenzungselemente (2, 8, 9, 41, 42, 43, 44, 45, 46, 50, 60, 70, 102, 108, 109, 191, 192, 302, 391a-391e, 392a-392e, 308a-308e, 309a-309e, 402, 408, 502, 508a, 508b, 509a, 509b, 510a, 510b), die das Volumen begrenzen und die derart ausgebildet sind, dass ein oder mehrere Durchlässe während einer Kompressions-, Expansions- oder Verdrängungsperiode ein Hinausströmen von maximal einer vorgegebenen Teilmenge der Flüssigkeitsmenge ermöglichen,
wobei während der Kompressions-, Expansions- oder Verdrängungsperiode die Flüssigkeitsmenge eine Rotation um eine Rotationsachse (10, 110, 310, 410, 510) ausführt,
wobei die Volumenbegrenzungselemente zudem derart ausgebildet sind, eine ringförmige Strömung der Flüssigkeitsmenge um die Rotationsachse (10, 110, 310, 410, 510) zu unterbinden,
wobei während der Kompressions-, Expansions- oder Verdrängungsperiode durch eine Verlagerung mindestens eines der Volumenbegrenzungselemente das Volumen in seiner Gesamtgröße veränderbar ist.

2. Vorrichtung nach Anspruch 1, wobei die Vorrichtung mindestens zwei der Volumina umfasst, die jeweils mindestens ein Teilvolumen des Arbeitsmediums und Flüssigkeitsmengen umfassen, wobei die mindestens zwei Volumina jeweils von den Volumenbegrenzungselementen begrenzt sind, so dass sich die Flüssigkeitsmengen verschiedener Volumina bis maximal auf die vorgegebene Teilmenge nicht vermischen.

3. Vorrichtung nach Anspruch 1 oder 2, wobei die vorgegebene Teilmenge 5% oder 10% oder 15% beträgt.

4. Vorrichtung nach einem der Ansprüche 1 bis 3, wobei mindestens ein erstes Volumenbegrenzungselement der Volumenbegrenzungselemente:
- eine Rotationsbewegung in einem Gehäuse (2, 102, 302, 402, 502, 602) ausführt, das das mindestens eine Volumen umfasst, wobei eine Rotationsachse des ersten Volumenbegrenzungselements verschieden von einer Mittelachse des Gehäuses ist und/oder
- eine erste Rotationsbewegung ausführt und mindestens ein zweites Volumenbegrenzungselement eine zweite Rotationsbewegung ausführt, wobei eine erste Rotationsachse der ersten Rotationsbewegung und eine zweite Rotationsachse der zweiten Rotationsbewegung verschieden voneinander sind.

5. Vorrichtung nach einem der Ansprüche 1 bis 4, wobei ein erstes Volumenbegrenzungselement der Volumenbegrenzungselemente, das eine Rotationsbewegung ausführt, bewegliche Begrenzungselemente umfasst, die während der Rotation des ersten Volumenbegrenzungselements ihre Lage relativ zu dem ersten Volumenbegrenzungselement periodisch ändern.

6. Vorrichtung nach einem der Ansprüche 1 bis 5, wobei ein erstes Volumenbegrenzungselement der Volumenbegrenzungselemente eine Bewegung ausführt, die eine Rotationsbewegung um eine erste Achse und eine Rotationsbewegung um eine zweite Achse umfasst.

7. Vorrichtung nach einem der Ansprüche 1 bis 6, wobei ein erstes Volumenbegrenzungselement der Volumenbegrenzungselemente eine Rotationsbewegung ausführt, deren Rotationsgeschwindigkeit in einem konstanten Verhältnis zur Rotationsbewegung eines Gehäuses steht.

8. Vorrichtung nach einem der Ansprüche 1 bis 3, wobei mindestens ein erstes Volumenbegrenzungselement der Volumenbegrenzungselemente ein Kolben oder Hohlkolben (508a, 508b, 509a, 509b) umfasst, der eine Rotationsbewegung ausführt, die von einer periodischen Translationsbewegung überlagert ist.

9. Vorrichtung nach einem der Ansprüche 1 bis 3, wobei sich mindestens eine der Flüssigkeitsmengen verursacht durch Trägheitskräfte oder durch Bewegung von mindestens einem der Volumenbegrenzungselemente im Volumen relativ zu anderen der Volumenbegrenzungselemente bewegt und dabei eine Größe mindestens eines der Teilvolumen ändert.

10. Vorrichtung nach einem der Ansprüche 1 bis 9, weiter umfassend Wärmeübertragungselemente, die periodisch in die im Volumen befindliche Flüssigkeit der Flüssigkeitsmenge ein- und wieder heraustauchen, wobei die Wärmeübertragungselemente beispielsweise Platten, Gitter und/oder Stäbe umfassen.

11. Thermoelektrischer Wandler zur Umwandlung von Wärmemengen in mechanische oder elektrische Energie oder zur Umwandlung von mechanischer oder elektrischer Energie in Wärme/Kälte oder zur Umwandlung von Wärmemengen bei ersten Temperaturen in Wärmemengen bei zweiten Temperaturen, der mindestens eine Vorrichtung nach einem der Ansprüche 1 bis 10 umfasst.

12. Thermoelektrischer Wandler nach Anspruch 11, wobei damit ein thermodynamischer Kreisprozess realisiert wird, beispielsweise ein Stirling-Prozess, ein Ericsson-Prozess, ein Clausius-Rankine-Prozess oder ein Stirling-Prozess, bei dem zusätzlich zur Kompression und Expansion oder Verdrängung des Arbeitsgases eine Kondensation und/oder Verdampfung eines Bestandteils des Arbeitsmediums oder der Flüssigkeit stattfindet.

13. Thermoelektrischer Wandler nach Anspruch 11 oder 12, der mindestens eine Vorrichtung nach einem der Ansprüche 4 bis 10 umfasst, wobei das Gehäuse frei drehbar um die Mittelachse des Gehäuses gelagert ist.

14. Computergesteuertes oder elektronisch gesteuertes Verfahren zum Betreiben eines thermoelektrischen Wandlers nach einem der Ansprüche 11 bis 13.

15. Das computergesteuerte oder elektronisch gesteuerte Verfahren nach Anspruch 14, wobei die Volumenänderungselemente (2, 8, 9, 40, 41, 42, 43, 44, 45, 46, 50, 60, 70, 102, 108, 109, 191, 192,, 302, 391a-391e, 392a-392e, 308a-308e, 309a-309e, 402, 408, 502, 508a, 508b, 509a, 509b, 510a, 510b) derart gesteuert wird, dass während einer Kompression des Arbeitsmediums dieses zumindest teilweise kondensiert und während einer anschließenden Expansion verdampft.
